# EUROPEAN PATENT APPLICATION

(11) **EP 4 790 924 A1**
(43) Date of publication of application: **12.08.2026**
(21) Application number: 24881231.5
(22) Date of filing: 26.08.2024
(51) Int. Cl.: H04B 10/516

(54) **DATA PROCESSING METHOD FOR OPTICAL COMMUNICATION, AND RELATED APPARATUS**

(30) Priority: 26.10.2023 CN 202311407243
(71) Applicant: HUAWEI TECHNOLOGIES CO., LTD., Shenzhen 518129 (CN)
(72) Inventor: HUANG, Kechao, Shenzhen, Guangdong 518129 (CN); YANG, Xiaoling, Shenzhen, Guangdong 518129 (CN); MA, Huixiao, Shenzhen, Guangdong 518129 (CN)
(74) Representative: Goddar, Heinz J.
(86) International application number: PCT/CN2024/114427
(87) International publication number: WO 2025/086863

(57) **Abstract**

Embodiments of this application disclose a data processing method for optical communication and a related apparatus, to improve performance of concatenated coding by using inner encoding with a higher gain, and achieve better compatibility with DP-16QAM and DP-QPSK modulation, thereby facilitating application in high-baud-rate long-distance transmission scenarios such as 800G and 1.6T-ZR scenarios. Specifically, a first bit set is first obtained, where the first bit set includes d₁ bits, d₁=244664×L, and L is a positive integer. Next, first FEC encoding is performed on the first bit set to obtain a second bit set, where the second bit set includes d₂ bits, every 261086 bits in the second bit set are obtained by performing the first FEC encoding on every 244664 bits in the first bit set, and d₂=261086×L. Then, d_{pad} padding bits are added to the second bit set to obtain a third bit set, where d_{pad} is an integer greater than or equal to 0. Further, second FEC encoding is performed on the third bit set to obtain a fourth bit set.

## Description

This application claims priority to Chinese Patent Application No. 202311407243.2, filed with the China National Intellectual Property Administration on October 26, 2023 and entitled "DATA PROCESSING METHOD FOR OPTICAL COMMUNICATION AND RELATED APPARATUS", which is incorporated herein by reference in its entirety.

### TECHNICAL FIELD

Embodiments of this application relate to the field of optical communication, and in particular, to a data processing method for optical communication and a related apparatus.

### BACKGROUND

Driven by continuous development of 5G, cloud computing, big data, artificial intelligence, and the like, a high-speed optical transport network is developing toward high capacity, packetization, and intelligence. A coherent optical communication system uses amplitudes, phases, polarization, and frequencies of optical waves to carry information. To resist optical signal distortion caused by dispersion, polarization-dependent impairment, noise, a nonlinear effect, and other factors in a transmission process and maintain long-distance transmission, the coherent optical communication system usually needs to use an efficient forward error correction (Forward Error Correction, FEC) code to prevent optical impairment in an optical transmission process, to ensure a low bit error ratio during long-distance transmission. In a 400G ZR scenario, an optical module uses CFEC cascading coding. An outer code uses a staircase (staircase, SC) code, an inner code uses a double-bit extended Hamming (Hamming) code, cascading coding redundancy is about 14.8%, and an error correction capability is a pre-correction bit error rate (1.25E-2).

For future metro telecommunication transmission and metro data center interconnect (Data Center Interconnect, DCI) scenarios, such as a 1.6T-ZR scenario, a baud rate is about 240 GB or even higher when dual-polarization 16-state quadrature amplitude modulation (Dual-polarization 16-state Quadrature Amplitude Modulation, DP-16QAM) is considered. For another example, a baud rate is about 240 GB or even higher when long-distance transmission of a 800G rate scenario using dual polarization quadrature phase shift keying (Dual polarization Quadrature Phase Shift Keying, DP-QPSK) modulation is considered. An existing data processing and transmission method using CFEC encoding is not applicable to a future scenario with a high baud rate. In addition, the existing data processing and transmission method using the CFEC encoding has poor adaptability in terms of compatibility with DP-QPSK modulation. This is a problem that needs to be urgently resolved in the future.

### SUMMARY

Embodiments of this application provide a data processing method for optical communication and a related apparatus, to improve performance of concatenated coding by using inner encoding with a higher gain. In addition, the specific data processing method is designed, to achieve better compatibility with DP-16QAM modulation and DP-QPSK modulation, thereby facilitating application in high-baud-rate long-distance transmission scenarios like a 1.6T-ZR scenario using DP-16QAM and a 800G scenario using DP-QPSK in the future.

According to a first aspect, an embodiment of this application provides a data processing method for optical communication. First, a first bit set is obtained, where the first bit set includes d₁ bits, d₁=244664×L, and L is a positive integer. Next, first forward error correction (forward error correction, FEC) encoding is performed on the first bit set to obtain a second bit set, where the second bit set includes d₂ bits, every 261086 bits in the second bit set are obtained by performing the first FEC encoding on every 244664 bits in the first bit set, and d₂=261086×L. Then, d_{pad} padding bits are added to the second bit set to obtain a third bit set, where d_{pad} is an integer greater than or equal to 0. Further, second FEC encoding is performed on the third bit set to obtain a fourth bit set.

In this implementation, the first FEC encoding (outer encoding) is performed at a granularity of 244664 bits, and the quantity d₁=244664 of bits in the obtained first bit set is also a multiple of 244664, so that a better effect is achieved. This facilitates hardware implementation, and achieves lower complexity. Based on this, performance of concatenated coding is improved by using inner encoding with a higher gain. In addition, a specific data processing method is designed, to achieve better compatibility with DP-16QAM and DP-QPSK modulation, thereby facilitating application in high-baud-rate long-distance transmission scenarios like a 1.6T-ZR scenario using DP-16QAM and a 800G scenario using DP-QPSK in the future.

In some possible implementations, the d₁ bits in the first bit set are distributed in r rows and 2056 columns, and r=119×L. A bit matrix uses row-column distribution of to-be-encoded bits, which achieves a good practical effect. The used 2056-column distribution is smaller than existing 10280-column distribution. This is more conducive to future scheme expansion.

In some possible implementations, every 261086 bits in the second bit set are distributed in 119 rows and 2194 columns, and first 2056 columns of the 2194 columns are used to carry 244664 bits in the first bit set. The total of 2056×119=244664 bits in the first 2056 columns in every 119 rows exactly carry the 244664 payload bits in the outer encoding. Therefore, this processing method has better data matching, so that hardware implementation is simple, and complexity is low.

In some possible implementations, every 261086 bits in the second bit set include 244664 bits in the first bit set, 32 first-type bits, six second-type bits, and 16384 check bits obtained through the first FEC encoding. In some specific applications, the 32 first-type bits are obtained by performing cyclic redundancy check (cyclic redundancy check, CRC) on the 244664 payload (payload) bits. Typically, the CRC uses CRC-32 check. In some other specific applications, the 32 first-type bits are 32 reserved bits, which are referred to as RES for short. The six second-type bits are a multi-group alignment signal (multi block alignment signal, MBAS).

In some possible implementations, after adding the d_{pad} padding bits to the second bit set to obtain the third bit set, and before performing the second FEC encoding on the third bit set to obtain the fourth bit set, the method further includes: performing first interleaving on the third bit set. Transfer of an error correlation between inner encoding and outer encoding can be reduced, to more effectively resist a burst error.

In some possible implementations, performing the first interleaving on the third bit set includes: delaying bits in the third bit set based on P delay lines. P is an integer greater than 1, a quantity of storage units included in each delay line is different, a delay line having a smallest quantity of storage units includes zero storage units, and a difference between quantities of storage units in every two adjacent delay lines is Q. Each storage unit is configured to store d bits, input bits are sequentially input into the P delay lines based on sequence numbers of the P delay lines, each delay line receives d bits per input and outputs d bits per output, P×d consecutive bits output through convolutional interleaving include d bits output from each delay line, and both Q and d are integers greater than or equal to 1 This implementation provides a specific implementation of the first interleaving, that is, is implemented through the convolutional interleaving, and has a good practical effect.

In some possible implementations, the fourth bit set includes R codewords, a length of each codeword is N bits, each codeword includes K information bits, R, N, K are all integers greater than 1, N is greater than K, the third bit set includes R×K bits, R×K=261086×L+d_{pad}, K is an integer multiple of d, P×d is an integer multiple of K, and $R \times \frac{K}{d}$ is an integer multiple of P. In this implementation, a length of the third bit set is an integer multiple of the information bit length K for the inner encoding. This facilitates fast outer-code synchronization after inner-code synchronization, so that hardware implementation is simple, and complexity is low.

In some possible implementations, a third bit set obtained through the first interleaving includes R rows and K columns of bits, and K bits in each row in the third bit set obtained through the first interleaving are K bits output from $\frac{K}{d}$ delay lines. Performing the second FEC encoding on the third bit set to obtain the fourth bit set includes: performing the second FEC encoding on the K bits in each row in the third bit set obtained through the first interleaving, to obtain N bits of each codeword in the fourth bit set. In this manner, before the convolutional interleaving is performed on data in the third bit set, a switch for input and output of the convolutional interleaver is initialized to a delay line 0. After all the data in the third bit set is input into the convolutional interleaver, the switch for input and output of the convolutional interleaver returns to the delay line 0. This facilitates synchronization of a de-convolutional interleaver at a receiver, so that hardware implementation is simple. Typically, K=d, and R is an integer multiple of P, so that a data processing procedure is simpler, and hardware implementation complexity is low.

In some possible implementations, the second FEC encoding uses BCH encoding or extended BCH encoding, so that performance of the concatenated coding is improved.

In some possible implementations, after adding the d_{pad} padding bits to the second bit set to obtain the third bit set, and before performing the second FEC encoding on the third bit set to obtain the fourth bit set, the method further includes: scrambling the third bit set. In this way, 0s and 1s in scrambled bit data tend to have more equal probabilities, thereby achieving direct current balance, which facilitates receiving at a receiver.

In some possible implementations, after performing the second FEC encoding on the third bit set to obtain the fourth bit set, the method further includes: performing data processing on the fourth bit set. The data processing includes symbol mapping, second interleaving, polarization distribution, and framing.

In some possible implementations, the fourth bit set includes R codewords, a length of each codeword is N bits, each codeword includes K information bits, R, N, and K are all integers greater than 1, and N is greater than K. K=113, and N=127; or K=113, and N=128; or K=112, and N=128; or K=110, and N=126; or K=119, and N=136; or K=119, and N=135. In the several inner encoding schemes provided in this implementation, an order of a used finite field is low, for ease of implementation of hardware.

In some possible implementations, K=113, N=127, and r and d_{pad} satisfy one of the following conditions:
r=119, and d_{pad}=1074;
r=238, and d_{pad}=340;
r=357, and d_{pad}=1414;
r=476, and d_{pad}=680;
r=595, and d_{pad}=1754;
r=714, and d_{pad}=1020;
r=833, and d_{pad}=286;
r=952, and d_{pad}=1360;
r=1071, and d_{pad}=626;
r=1190, and d_{pad}=1700;
r=1309, and d_{pad}=966;
r=1428, and d_{pad}=232;
r=1547, and d_{pad}=1306;
r=1666, and d_{pad}=572;
r=1785, and d_{pad}=1646;
r=1904, and d_{pad}=912;
r=2023, and d_{pad}=178;
r=2142, and d_{pad}=1252;
r=2261, and d_{pad}=518; or
r=2380, and d_{pad}=1592.

In some possible implementations, K=113, N=128, and r and d_{pad} satisfy one of the following conditions:
r=119, and d_{pad}=1074;
r=238, and d_{pad}=340;
r=357, and d_{pad}=1414;
r=476, and d_{pad}=680;
r=595, and d_{pad}=1754;
r=714, and d_{pad}=1020;
r=833, and d_{pad}=286;
r=952, and d_{pad}=1360;
r=1071, and d_{pad}=626;
r=1190, and d_{pad}=1700;
r=1309, and d_{pad}=966;
r=1428, and d_{pad}=232;
r=1547, and d_{pad}=1306;
r=1666, and d_{pad}=572;
r=1785, and d_{pad}=1646;
r=1904, and d_{pad}=912;
r=2023, and d_{pad}=178;
r=2142, and d_{pad}=1252;
r=2261, and d_{pad}=518; or
r=2380, and d_{pad}=1592.

In some possible implementations, K=112, N=128, and r and d_{pad} satisfy one of the following conditions:
r=119, and d_{pad}=546;
r=238, and d_{pad}=1092;
r=357, and d_{pad}=1638;
r=476, and d_{pad}=392;
r=595, and d_{pad}=938;
r=714, and d_{pad}=1484;
r=833, and d_{pad}=238;
r=952, and d_{pad}=784;
r=1071, and d_{pad}=1330;
r=1190, and d_{pad}=84;
r=1309, and d_{pad}=630;
r=1428, and d_{pad}=1176;
r=1547, and d_{pad}=1722;
r=1666, and d_{pad}=476;
r=1785, and d_{pad}=1022;
r=1904, and d_{pad}=1568;
r=2023, and d_{pad}=322;
₁=2142, and d_{pad}=868;
r=2261, and d_{pad}=1414; or
r=2380, and d_{pad}=168.

In some possible implementations, K=110, N=126, and r and d_{pad} satisfy one of the following conditions:
r=119, and d_{pad}=1154;
r=238, and d_{pad}=548;
r=357, and d_{pad}=1702;
r=476, and d_{pad}=1096;
r=595, and d_{pad}=490;
r=714, and d_{pad}=1644;
r=833, and d_{pad}=1038;
r=952, and d_{pad}=432;
r=1071, and d_{pad}=1586;
r=1190, and d_{pad}=980;
r=1309, and d_{pad}=374;
r=1428, and d_{pad}=1528;
r=1547, and d_{pad}=922;
r=1666, and d_{pad}=316;
r=1785, and d_{pad}=1470;
r=1904, and d_{pad}=864;
r=2023, and d_{pad}=258;
r=2142, and d_{pad}=1412;
r=2261, and d_{pad}=806; or
r=2380, and d_{pad}=200.

In some possible implementations, K=119, N=136, and r and d_{pad} satisfy one of the following conditions:
r=119, and d_{pad}=1666;
r=238, and d_{pad}=1428;
r=357, and d_{pad}=1190;
r=476, and d_{pad}=952;
r=595, and d_{pad}=714;
r=714, and d_{pad}=476;
r=833, and d_{pad}=238;
r=952, and d_{pad}=1904;
r=1071, and d_{pad}=1666;
r=1190, and d_{pad}=1428;
r=1309, and d_{pad}=1190;
r=1428, and d_{pad}=952;
r=1547, and d_{pad}=714;
r=1666, and d_{pad}=476;
r=1785, and d_{pad}=238;
r=1904, and d_{pad}=0;
r=2023, and d_{pad}=1666;
r=2142, and d_{pad}=1428;
r=2261, and d_{pad}=1190; or
r=2380, and d_{pad}=952.

In some possible implementations, K=119, N=135, and r and d_{pad} satisfy one of the following conditions:
r=119, and d_{pad}=1666;
r=238, and d_{pad}=1428;
r=357, and d_{pad}=1190;
r=476, and d_{pad}=952;
r=595, and d_{pad}=714;
r=714, and d_{pad}=476;
r=833, and d_{pad}=238;
r=952, and d_{pad}=1904;
r=1071, and d_{pad}=1666;
r=1190, and d_{pad}=1428;
r=1309, and d_{pad}=1190;
r=1428, and d_{pad}=952;
r=1547, and d_{pad}=714;
r=1666, and d_{pad}=476;
r=1785, and d_{pad}=238;
r=1904, and d_{pad}=0;
r=2023, and d_{pad}=1666;
₁=2142, and d_{pad}=1428;
r=2261, and d_{pad}=1190; or
r=2380, and d_{pad}=952.

According to a second aspect, an embodiment of this application provides a data processing apparatus. The data processing apparatus includes: an obtaining unit, a first encoding unit, a padding unit, and a second encoding unit. The obtaining unit is configured to obtain a first bit set, where the first bit set includes d₁ bits, d₁=244664×L, and L is a positive integer. The first encoding unit is configured to perform first forward error correction FEC encoding on the first bit set to obtain a second bit set, where the second bit set includes d₂ bits, every 261086 bits in the second bit set are obtained by performing the first FEC encoding on every 244664 bits in the first bit set, and d₂=261086×L. The padding unit is configured to add d_{pad} padding bits to the second bit set to obtain a third bit set, where d_{pad} is an integer greater than or equal to 0. The second encoding unit is configured to perform second FEC encoding on the third bit set to obtain a fourth bit set.

In this implementation, the first FEC encoding (outer encoding) is performed at a granularity of 244664 bits, and the quantity d₁=244664 of bits in the obtained first bit set is also a multiple of 244664, so that a better effect is achieved. This facilitates hardware implementation, and achieves lower complexity. Based on this, performance of concatenated coding is improved by using inner encoding with a higher gain. In addition, a specific data processing method is designed, to achieve better compatibility with DP-16QAM and DP-QPSK modulation, thereby facilitating application in high-baud-rate long-distance transmission scenarios like a 1.6T-ZR scenario using DP-16QAM and a 800G scenario using DP-QPSK in the future.

In some possible implementations, the d₁ bits in the first bit set are distributed in r rows and 2056 columns, and r=119×L. A bit matrix uses row-column distribution of to-be-encoded bits, which achieves a good practical effect. The used 2056-column distribution is smaller than existing 10280-column distribution. This is more conducive to future scheme expansion.

In some possible implementations, every 261086 bits in the second bit set are distributed in 119 rows and 2194 columns, and first 2056 columns of the 2194 columns are used to carry 244664 bits in the first bit set. The total of 2056×119=244664 bits in the first 2056 columns in every 119 rows exactly carry the 244664 payload bits in the outer encoding. Therefore, this processing method has better data matching, so that hardware implementation is simple, and complexity is low.

In some possible implementations, every 261086 bits in the second bit set include 244664 bits in the first bit set, 32 first-type bits, six second-type bits, and 16384 check bits obtained through the first FEC encoding. In some specific applications, the 32 first-type bits are obtained by performing CRC on the 244664 payload (payload) bits. Typically, the CRC uses CRC-32 check. In some other specific applications, the 32 first-type bits are 32 reserved bits, which are referred to as RES for short. The six second-type bits are an MBAS.

In some possible implementations, the data processing apparatus further includes an interleaving unit. After the d_{pad} padding bits are added to the second bit set to obtain the third bit set, and before the second FEC encoding is performed on the third bit set to obtain the fourth bit set, the interleaving unit is configured to: perform first interleaving on the third bit set. Transfer of an error correlation between inner encoding and outer encoding can be reduced, to more effectively resist a burst error.

In some possible implementations, the interleaving unit is specifically configured to: delay bits in the third bit set based on P delay lines. P is an integer greater than 1, a quantity of storage units included in each delay line is different, a delay line having a smallest quantity of storage units includes zero storage units, and a difference between quantities of storage units in every two adjacent delay lines is Q. Each storage unit is configured to store d bits, input bits are sequentially input into the P delay lines based on sequence numbers of the P delay lines, each delay line receives d bits per input and outputs d bits per output, P×d consecutive bits output through convolutional interleaving include d bits output from each delay line, and both Q and d are integers greater than or equal to 1 This implementation provides a specific implementation of the first interleaving, that is, is implemented through the convolutional interleaving, and has a good practical effect.

In some possible implementations, the fourth bit set includes R codewords, a length of each codeword is N bits, each codeword includes K information bits, R, N, K are all integers greater than 1, N is greater than K, the third bit set includes R×K bits, R×K=261086×L+d_{pad}, K is an integer multiple of d, P×d is an integer multiple of K, and $R \times \frac{K}{d}$ is an integer multiple of P. In this implementation, a length of the third bit set is an integer multiple of the information bit length K for the inner encoding. This facilitates fast outer-code synchronization after inner-code synchronization, so that hardware implementation is simple, and complexity is low.

In some possible implementations, a third bit set obtained through the first interleaving includes R rows and K columns of bits, and K bits in each row in the third bit set obtained through the first interleaving are K bits output from $\frac{K}{d}$ delay lines. Performing the second FEC encoding on the third bit set to obtain the fourth bit set includes: performing the second FEC encoding on the K bits in each row in the third bit set obtained through the first interleaving, to obtain N bits of each codeword in the fourth bit set. In this manner, before the convolutional interleaving is performed on data in the third bit set, a switch for input and output of the convolutional interleaver is initialized to a delay line 0. After all the data in the third bit set is input into the convolutional interleaver, the switch for input and output of the convolutional interleaver returns to the delay line 0. This facilitates synchronization of a de-convolutional interleaver at a receiver, so that hardware implementation is simple. Typically, K=d, and R is an integer multiple of P, so that a data processing procedure is simpler, and hardware implementation complexity is low.

In some possible implementations, the second FEC encoding uses BCH encoding or extended BCH encoding, so that performance of the concatenated coding is improved.

In some possible implementations, the data processing apparatus further includes a scrambling unit. After the d_{pad} padding bits are added to the second bit set to obtain the third bit set, and before the second FEC encoding is performed on the third bit set to obtain the fourth bit set, the scrambling unit is configured to scramble the third bit set, so that 0s and 1s in scrambled bit data tend to have more equal probabilities, thereby achieving direct current balance, which facilitates receiving at a receiver.

In some possible implementations, the data processing apparatus further includes a data processing unit. After the second FEC encoding is performed on the third bit set to obtain the fourth bit set, the data processing unit is configured to perform data processing on the fourth bit set. The data processing includes symbol mapping, second interleaving, polarization distribution, and framing.

In some possible implementations, the fourth bit set includes R codewords, a length of each codeword is N bits, each codeword includes K information bits, R, N, and K are all integers greater than 1, and N is greater than K. K=113, and N=127; or K=113, and N=128; or K=112, and N=128; or K=110, and N=126; or K=119, and N=136; or K=119, and N=135. In the several inner encoding schemes provided in this implementation, an order of a used finite field is low, for ease of implementation of hardware.

In some possible implementations, K=113, N=127, and r and d_{pad} satisfy one of the following conditions:
r=119, and d_{pad}=1074;
r=238, and d_{pad}=340;
r=357, and d_{pad}=1414;
r=476, and d_{pad}=680;
r=595, and d_{pad}=1754;
r=714, and d_{pad}=1020;
r=833, and d_{pad}=286;
r=952, and d_{pad}=1360;
r=1071, and d_{pad}=626;
r=1190, and d_{pad}=1700;
r=1309, and d_{pad}=966;
r=1428, and d_{pad}=232;
r=1547, and d_{pad}=1306;
r=1666, and d_{pad}=572;
r=1785, and d_{pad}=1646;
r=1904, and d_{pad}=912;
r=2023, and d_{pad}=178;
r=2142, and d_{pad}=1252;
r=2261, and d_{pad}=518; or
r=2380, and d_{pad}=1592.

In some possible implementations, K=113, N=128, and r and d_{pad} satisfy one of the following conditions:
r=119, and d_{pad}=1074;
r=238, and d_{pad}=340;
r=357, and d_{pad}=1414;
r=476, and d_{pad}=680;
r=595, and d_{pad}=1754;
r=714, and d_{pad}=1020;
r=833, and d_{pad}=286;
r=952, and d_{pad}=1360;
r=1071, and d_{pad}=626;
r=1190, and d_{pad}=1700;
r=1309, and d_{pad}=966;
r=1428, and d_{pad}=232;
r=1547, and d_{pad}=1306;
r=1666, and d_{pad}=572;
r=1785, and d_{pad}=1646;
r=1904, and d_{pad}=912;
r=2023, and d_{pad}=178;
r=2142, and d_{pad}=1252;
r=2261, and d_{pad}=518; or
r=2380, and d_{pad}=1592.

In some possible implementations, K=112, N=128, and r and d_{pad} satisfy one of the following conditions:
r=119, and d_{pad}=546;
r=238, and d_{pad}=1092;
r=357, and d_{pad}=1638;
r=476, and d_{pad}=392;
r=595, and d_{pad}=938;
r=714, and d_{pad}=1484;
r=833, and d_{pad}=238;
r=952, and d_{pad}=784;
r=1071, and d_{pad}=1330;
r=1190, and d_{pad}=84;
r=1309, and d_{pad}=630;
r=1428, and d_{pad}=1176;
r=1547, and d_{pad}=1722;
r=1666, and d_{pad}=476;
r=1785, and d_{pad}=1022;
r=1904, and d_{pad}=1568;
r=2023, and d_{pad}=322;
₁=2142, and d_{pad}=868;
r=2261, and d_{pad}=1414; or
r=2380, and d_{pad}=168.

In some possible implementations, K=110, N=126, and r and d_{pad} satisfy one of the following conditions:
r=119, and d_{pad}=1154;
r=238, and d_{pad}=548;
r=357, and d_{pad}=1702;
r=476, and d_{pad}=1096;
r=595, and d_{pad}=490;
r=714, and d_{pad}=1644;
r=833, and d_{pad}=1038;
r=952, and d_{pad}=432;
r=1071, and d_{pad}=1586;
r=1190, and d_{pad}=980;
r=1309, and d_{pad}=374;
r=1428, and d_{pad}=1528;
r=1547, and d_{pad}=922;
r=1666, and d_{pad}=316;
r=1785, and d_{pad}=1470;
r=1904, and d_{pad}=864;
r=2023, and d_{pad}=258;
r=2142, and d_{pad}=1412;
r=2261, and d_{pad}=806; or
r=2380, and d_{pad}=200.

In some possible implementations, K=119, N=136, and r and d_{pad} satisfy one of the following conditions:
r=119, and d_{pad}=1666;
r=238, and d_{pad}=1428;
r=357, and d_{pad}=1190;
r=476, and d_{pad}=952;
r=595, and d_{pad}=714;
r=714, and d_{pad}=476;
r=833, and d_{pad}=238;
r=952, and d_{pad}=1904;
r=1071, and d_{pad}=1666;
r=1190, and d_{pad}=1428;
r=1309, and d_{pad}=1190;
r=1428, and d_{pad}=952;
r=1547, and d_{pad}=714;
r=1666, and d_{pad}=476;
r=1785, and d_{pad}=238;
r=1904, and d_{pad}=0;
r=2023, and d_{pad}=1666;
r=2142, and d_{pad}=1428;
r=2261, and d_{pad}=1190; or
r=2380, and d_{pad}=952.

In some possible implementations, K=119, N=135, and r and d_{pad} satisfy one of the following conditions:
r=119, and d_{pad}=1666;
r=238, and d_{pad}=1428;
r=357, and d_{pad}=1190;
r=476, and d_{pad}=952;
r=595, and d_{pad}=714;
r=714, and d_{pad}=476;
r=833, and d_{pad}=238;
r=952, and d_{pad}=1904;
r=1071, and d_{pad}=1666;
r=1190, and d_{pad}=1428;
r=1309, and d_{pad}=1190;
r=1428, and d_{pad}=952;
r=1547, and d_{pad}=714;
r=1666, and d_{pad}=476;
r=1785, and d_{pad}=238;
r=1904, and d_{pad}=0;
r=2023, and d_{pad}=1666;
r=2142, and d_{pad}=1428;
r=2261, and d_{pad}=1190; or
r=2380, and d_{pad}=952.

According to a third aspect, an embodiment of this application provides a data processing apparatus. The data processing apparatus includes a processor. The processor is configured to perform the following operations. First, a first bit set is obtained, where the first bit set includes d₁ bits, d₁=244664×L, and L is a positive integer. Next, first forward error correction (forward error correction, FEC) encoding is performed on the first bit set to obtain a second bit set, where the second bit set includes d₂ bits, every 261086 bits in the second bit set are obtained by performing the first FEC encoding on every 244664 bits in the first bit set, and d₂=261086×L. Then, d_{pad} padding bits are added to the second bit set to obtain a third bit set, where d_{pad} is an integer greater than or equal to 0. Further, second FEC encoding is performed on the third bit set to obtain a fourth bit set.

In this implementation, the first FEC encoding (outer encoding) is performed at a granularity of 244664 bits, and the quantity d₁=244664 of bits in the obtained first bit set is also a multiple of 244664, so that a better effect is achieved. This facilitates hardware implementation, and achieves lower complexity. Based on this, performance of concatenated coding is improved by using inner encoding with a higher gain. In addition, a specific data processing method is designed, to achieve better compatibility with DP-16QAM and DP-QPSK modulation, thereby facilitating application in high-baud-rate long-distance transmission scenarios like a 1.6T-ZR scenario using DP-16QAM and a 800G scenario using DP-QPSK in the future.

In some possible implementations, the d₁ bits in the first bit set are distributed in r rows and 2056 columns, and r=119×L. A bit matrix uses row-column distribution of to-be-encoded bits, which achieves a good practical effect. The used 2056-column distribution is smaller than existing 10280-column distribution. This is more conducive to future scheme expansion.

In some possible implementations, every 261086 bits in the second bit set are distributed in 119 rows and 2194 columns, and first 2056 columns of the 2194 columns are used to carry 244664 bits in the first bit set. The total of 2056×119=244664 bits in the first 2056 columns in every 119 rows exactly carry the 244664 payload bits in the outer encoding. Therefore, this processing method has better data matching, so that hardware implementation is simple, and complexity is low.

In some possible implementations, every 261086 bits in the second bit set include 244664 bits in the first bit set, 32 first-type bits, six second-type bits, and 16384 check bits obtained through the first FEC encoding. In some specific applications, the 32 first-type bits are obtained by performing CRC on the 244664 payload (payload) bits. Typically, the CRC uses CRC-32 check. In some other specific applications, the 32 first-type bits are 32 reserved bits, which are referred to as RES for short. The six second-type bits are an MBAS.

In some possible implementations, after the d_{pad} padding bits are added to the second bit set to obtain the third bit set, and before the second FEC encoding is performed on the third bit set to obtain the fourth bit set, the processor is further configured to: perform first interleaving on the third bit set. Transfer of an error correlation between inner encoding and outer encoding can be reduced, to more effectively resist a burst error.

In some possible implementations, the processor is specifically configured to delay bits in the third bit set based on P delay lines. P is an integer greater than 1, a quantity of storage units included in each delay line is different, a delay line having a smallest quantity of storage units includes zero storage units, and a difference between quantities of storage units in every two adjacent delay lines is Q. Each storage unit is configured to store d bits, input bits are sequentially input into the P delay lines based on sequence numbers of the P delay lines, each delay line receives d bits per input and outputs d bits per output, P×d consecutive bits output through convolutional interleaving include d bits output from each delay line, and both Q and d are integers greater than or equal to 1 This implementation provides a specific implementation of the first interleaving, that is, is implemented through the convolutional interleaving, and has a good practical effect.

In some possible implementations, the fourth bit set includes R codewords, a length of each codeword is N bits, each codeword includes K information bits, R, N, K are all integers greater than 1, N is greater than K, the third bit set includes R×K bits, R×K=261086×L+d_{pad}, K is an integer multiple of d, P×d is an integer multiple of K, and $R \times \frac{K}{d}$ is an integer multiple of P. In this implementation, a length of the third bit set is an integer multiple of the information bit length K for the inner encoding. This facilitates fast outer-code synchronization after inner-code synchronization, so that hardware implementation is simple, and complexity is low.

In some possible implementations, a third bit set obtained through the first interleaving includes R rows and K columns of bits, and K bits in each row in the third bit set obtained through the first interleaving are K bits output from $\frac{K}{d}$ delay lines. Performing the second FEC encoding on the third bit set to obtain the fourth bit set includes: performing the second FEC encoding on the K bits in each row in the third bit set obtained through the first interleaving, to obtain N bits of each codeword in the fourth bit set. In this manner, before the convolutional interleaving is performed on data in the third bit set, a switch for input and output of the convolutional interleaver is initialized to a delay line 0. After all the data in the third bit set is input into the convolutional interleaver, the switch for input and output of the convolutional interleaver returns to the delay line 0. This facilitates synchronization of a de-convolutional interleaver at a receiver, so that hardware implementation is simple. Typically, K=d, and R is an integer multiple of P, so that a data processing procedure is simpler, and hardware implementation complexity is low.

In some possible implementations, the second FEC encoding uses BCH encoding or extended BCH encoding, so that performance of the concatenated coding is improved.

In some possible implementations, after the d_{pad} padding bits are added to the second bit set to obtain the third bit set, and before the second FEC encoding is performed on the third bit set to obtain the fourth bit set, the processor is further configured to: scramble the third bit set. In this way, 0s and 1s in scrambled bit data tend to have more equal probabilities, thereby achieving direct current balance, which facilitates receiving at a receiver.

In some possible implementations, after the second FEC encoding is performed on the third bit set to obtain the fourth bit set, the processor is further configured to perform data processing on the fourth bit set. The data processing includes symbol mapping, second interleaving, polarization distribution, and framing. The data processing apparatus further includes an interface circuit. The interface circuit is configured to send a data frame obtained by performing data processing on the fourth bit set.

In some possible implementations, the fourth bit set includes R codewords, a length of each codeword is N bits, each codeword includes K information bits, R, N, and K are all integers greater than 1, and N is greater than K. K=113, and N=127; or K=113, and N=128; or K=112, and N=128; or K=110, and N=126; or K=119, and N=136; or K=119, and N=135. In the several inner encoding schemes provided in this implementation, an order of a used finite field is low, for ease of implementation of hardware.

In some possible implementations, K=113, N=127, and r and d_{pad} satisfy one of the following conditions:
r=119, and d_{pad}=1074;
r=238, and d_{pad}=340;
r=357, and d_{pad}=1414;
r=476, and d_{pad}=680;
r=595, and d_{pad}=1754;
r=714, and d_{pad}=1020;
r=833, and d_{pad}=286;
r=952, and d_{pad}=1360;
r=1071, and d_{pad}=626;
r=1190, and d_{pad}=1700;
r=1309, and d_{pad}=966;
r=1428, and d_{pad}=232;
r=1547, and d_{pad}=1306;
r=1666, and d_{pad}=572;
r=1785, and d_{pad}=1646;
r=1904, and d_{pad}=912;
r=2023, and d_{pad}=178;
r=2142, and d_{pad}=1252;
r=2261, and d_{pad}=518; or
r=2380, and d_{pad}=1592.

In some possible implementations, K=113, N=128, and r and d_{pad} satisfy one of the following conditions:
r=119, and d_{pad}=1074;
r=238, and d_{pad}=340;
r=357, and d_{pad}=1414;
r=476, and d_{pad}=680;
r=595, and d_{pad}=1754;
r=714, and d_{pad}=1020;
r=833, and d_{pad}=286;
r=952, and d_{pad}=1360;
r=1071, and d_{pad}=626;
r=1190, and d_{pad}=1700;
r=1309, and d_{pad}=966;
r=1428, and d_{pad}=232;
r=1547, and d_{pad}=1306;
r=1666, and d_{pad}=572;
r=1785, and d_{pad}=1646;
r=1904, and d_{pad}=912;
r=2023, and d_{pad}=178;
r=2142, and d_{pad}=1252;
r=2261, and d_{pad}=518; or
r=2380, and d_{pad}=1592.

In some possible implementations, K=112, N=128, and r and d_{pad} satisfy one of the following conditions:
r=119, and d_{pad}=546;
r=238, and d_{pad}=1092;
r=357, and d_{pad}=1638;
r=476, and d_{pad}=392;
r=595, and d_{pad}=938;
r=714, and d_{pad}=1484;
r=833, and d_{pad}=238;
r=952, and d_{pad}=784;
r=1071, and d_{pad}=1330;
r=1190, and d_{pad}=84;
r=1309, and d_{pad}=630;
r=1428, and d_{pad}=1176;
r=1547, and d_{pad}=1722;
r=1666, and d_{pad}=476;
r=1785, and d_{pad}=1022;
r=1904, and d_{pad}=1568;
r=2023, and d_{pad}=322;
r=2142, and d_{pad}=868;
r=2261, and d_{pad}=1414; or
r=2380, and d_{pad}=168.

In some possible implementations, K=110, N=126, and r and d_{pad} satisfy one of the following conditions:
r=119, and d_{pad}=1154;
r=238, and d_{pad}=548;
r=357, and d_{pad}=1702;
r=476, and d_{pad}=1096;
r=595, and d_{pad}=490;
r=714, and d_{pad}=1644;
r=833, and d_{pad}=1038;
r=952, and d_{pad}=432;
r=1071, and d_{pad}=1586;
r=1190, and d_{pad}=980;
r=1309, and d_{pad}=374;
r=1428, and d_{pad}=1528;
r=1547, and d_{pad}=922;
r=1666, and d_{pad}=316;
r=1785, and d_{pad}=1470;
r=1904, and d_{pad}=864;
r=2023, and d_{pad}=258;
r=2142, and d_{pad}=1412;
r=2261, and d_{pad}=806; or
r=2380, and d_{pad}=200.

In some possible implementations, K=119, N=136, and r and d_{pad} satisfy one of the following conditions:
r=119, and d_{pad}=1666;
r=238, and d_{pad}=1428;
r=357, and d_{pad}=1190;
r=476, and d_{pad}=952;
r=595, and d_{pad}=714;
r=714, and d_{pad}=476;
r=833, and d_{pad}=238;
r=952, and d_{pad}=1904;
r=1071, and d_{pad}=1666;
r=1190, and d_{pad}=1428;
r=1309, and d_{pad}=1190;
r=1428, and d_{pad}=952;
r=1547, and d_{pad}=714;
r=1666, and d_{pad}=476;
r=1785, and d_{pad}=238;
r=1904, and d_{pad}=0;
r=2023, and d_{pad}=1666;
r=2142, and d_{pad}=1428;
r=2261, and d_{pad}=1190; or
r=2380, and d_{pad}=952.

In some possible implementations, K=119, N=135, and r and d_{pad} satisfy one of the following conditions:
r=119, and d_{pad}=1666;
r=238, and d_{pad}=1428;
r=357, and d_{pad}=1190;
r=476, and d_{pad}=952;
r=595, and d_{pad}=714;
r=714, and d_{pad}=476;
r=833, and d_{pad}=238;
r=952, and d_{pad}=1904;
r=1071, and d_{pad}=1666;
r=1190, and d_{pad}=1428;
r=1309, and d_{pad}=1190;
r=1428, and d_{pad}=952;
r=1547, and d_{pad}=714;
r=1666, and d_{pad}=476;
r=1785, and d_{pad}=238;
r=1904, and d_{pad}=0;
r=2023, and d_{pad}=1666;
r=2142, and d_{pad}=1428;
r=2261, and d_{pad}=1190; or
r=2380, and d_{pad}=952.

According to a fourth aspect, an embodiment of this application provides an optical module. The optical module includes a processor, and the processor is configured to perform the method described in any implementation of the first aspect.

In some possible implementations, the optical module further includes an interface circuit. The processor performs data processing including symbol mapping, second interleaving, polarization distribution, and framing on a fourth bit set to obtain a data frame, and then sends the data frame via the interface circuit.

According to a fifth aspect, an embodiment of this application provides a chip. The chip includes a processor, and the processor is configured to perform the method described in any implementation of the first aspect.

According to a sixth aspect, an embodiment of this application provides a data transmission system. The data transmission system includes a data sending device and a data receiving device. The data sending device is configured to: perform the method described in any implementation of the first aspect, and send data to the data receiving device. The data receiving device is configured to perform an operation like decoding on the received data.

According to a seventh aspect, an embodiment of this application provides a computer-readable storage medium. The computer-readable storage medium stores a computer program. When the computer program is executed by a computer, the method described in any implementation of the first aspect is implemented.

According to the foregoing technical solutions, it can be learned that embodiments of this application have the following advantages:
In this implementation, the first FEC encoding (outer encoding) is performed at a granularity of 244664 bits, and the quantity d₁=244664 of bits in the obtained first bit set is also a multiple of 244664, so that a better effect is achieved. This facilitates hardware implementation, and achieves lower complexity. Based on this, performance of concatenated coding is improved by using inner encoding with a higher gain. In addition, a specific data processing method is designed, to achieve better compatibility with DP-16QAM and DP-QPSK modulation, thereby facilitating application in high-baud-rate long-distance transmission scenarios like a 1.6T-ZR scenario using DP-16QAM and a 800G scenario using DP-QPSK in the future.

### BRIEF DESCRIPTION OF DRAWINGS

FIG. 1 is a diagram of a communication system to which an embodiment of this application is applied;
FIG. 2 is a diagram of another communication system to which an embodiment of this application is applied;
FIG. 3 is a diagram of an implementation of a transmitter data processor according to an embodiment of this application;
FIG. 4 is a diagram of another implementation of a transmitter data processor according to an embodiment of this application;
FIG. 5 is a diagram of still another implementation of a transmitter data processor according to an embodiment of this application;
FIG. 6 is a diagram of yet another implementation of a transmitter data processor according to an embodiment of this application;
FIG. 7 is a schematic flowchart of a data processing method for optical communication according to an embodiment of this application;
FIG. 8 is a diagram of a first bit set according to an embodiment of this application;
FIG. 9 is a diagram of bit distribution of outer encoding according to an embodiment of this application;
FIG. 10a is a diagram of a second bit set according to an embodiment of this application;
FIG. 10b is another diagram of a second bit set according to an embodiment of this application;
FIG. 11 is a diagram of a third bit set according to an embodiment of this application;
FIG. 12 is another diagram of a third bit set according to an embodiment of this application;
FIG. 13a is a diagram of a first implementation of convolutional interleaving according to an embodiment of this application;
FIG. 13b is a diagram of a second implementation of convolutional interleaving according to an embodiment of this application;
FIG. 14 is a diagram of an implementation of performing inner encoding on a fourth bit set according to an embodiment of this application;
FIG. 15 is a diagram of another implementation of first data processing according to an embodiment of this application;
FIG. 16 is a diagram of another implementation of first data processing according to an embodiment of this application;
FIG. 17 is a diagram of another implementation of first data processing according to an embodiment of this application;
FIG. 18 is a diagram of another implementation of first data processing according to an embodiment of this application;
FIG. 19 is a diagram of another implementation of first data processing according to an embodiment of this application;
FIG. 20 is a diagram of a structure of a data processing apparatus according to an embodiment of this application; and
FIG. 21 is a diagram of another structure of a data processing apparatus according to an embodiment of this application.

### DESCRIPTION OF EMBODIMENTS

Embodiments of this application provide a data processing method for optical communication and a related apparatus, to improve performance of concatenated coding by using inner encoding with a higher gain. In addition, the specific data processing method is designed, to achieve better compatibility with DP-16QAM modulation and DP-QPSK modulation, thereby facilitating application in high-baud-rate long-distance transmission scenarios like a 1.6T-ZR scenario using DP-16QAM and a 800G scenario using DP-QPSK in the future.

It should be noted that, the terms "first", "second", and the like in the specification, claims, and accompanying drawings of this application are intended to distinguish between similar objects but do not necessarily indicate a specific order or sequence. It should be understood that the foregoing terms are interchangeable in proper circumstances, so that embodiments described in this application can be implemented in other orders than the order described in this application. Moreover, the terms "include", "have", or any other variant thereof are intended to cover non-exclusive inclusion. For example, processes, methods, systems, products, or devices that include a series of steps or units are not limited to the steps or the units that are clearly listed, and may include other steps and units that are not clearly listed or that are inherent to the processes, methods, products, or devices.

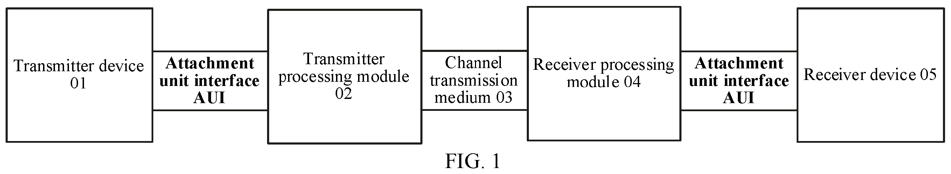

FIG. 1 is a diagram of a communication system to which an embodiment of this application is applied. As shown in FIG. 1, the communication system includes a transmitter device 01, a transmitter processing module 02, a channel transmission medium 03, a receiver processing module 04, and a receiver device 05. For example, the communication system is a data center network. The transmitter device 01 and the receiver device 05 may be devices such as switches or routers, and the transmitter device 01 is also referred to as a host chip (host chip) located at a transmitter, the receiver device 05 is also referred to as a host chip located at a receiver, and the channel transmission medium 03 may be an optical fiber. The host chip is also sometimes referred to as a host device (host device). The transmitter device 01 may be connected to the transmitter processing module 02 through an attachment unit interface (attachment unit interface, AUI), and the receiver device 05 may be connected to the receiver processing module 04 through an AUI. The transmitter processing module 02 and the receiver processing module 04 may each be an optical module (optical module), an electrical module, a connector (connector), or another module that processes data in a data transmission process. For example, the processing module may be an 800G ZR module (800G ZR module, which is a coherent optical module). In addition, the transmitter device 01, the transmitter processing module 02, the channel transmission medium 03, the receiver processing module 04, and the receiver device 05 in the communication system may all support bidirectional transmission or unidirectional transmission. This is not specifically limited herein.

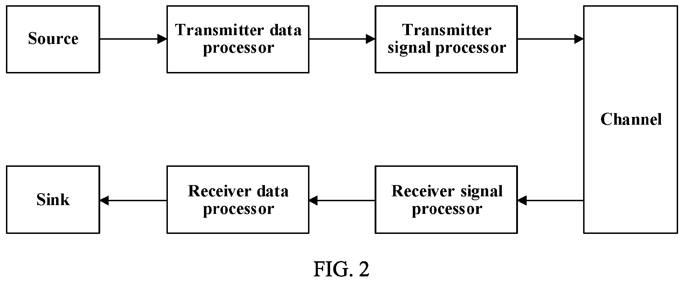

FIG. 2 is a diagram of another communication system to which an embodiment of this application is applied. As shown in FIG. 2, at a transmitter, a source provides a to-be-sent data stream; and a transmitter data processor receives the data stream, performs data processing including encoding, interleaving, modulation, and DSP framing on the data stream to obtain a symbol data stream, sends the symbol data stream to a transmitter signal processor for transmitter signal preprocessing, and transmits the symbol data stream to a receiving device through a channel. After receiving a signal that is distorted due to noise or other impairments on the channel, the receiving device sends the signal to a receiver signal processor for clock synchronization, dispersion compensation, and other operations. Then, the signal is sent to a receiver data processor for operations including frame alignment, demodulation, de-interleaving, and decoding, to restore original data, and send the data to a sink. The transmitter data processor and the transmitter signal processor shown in FIG. 2 may be used in the transmitter processing module 02 shown in FIG. 1, and the receiver data processor and the receiver signal processor shown in FIG. 2 may be used in the receiver processing module 04 shown in FIG. 1.

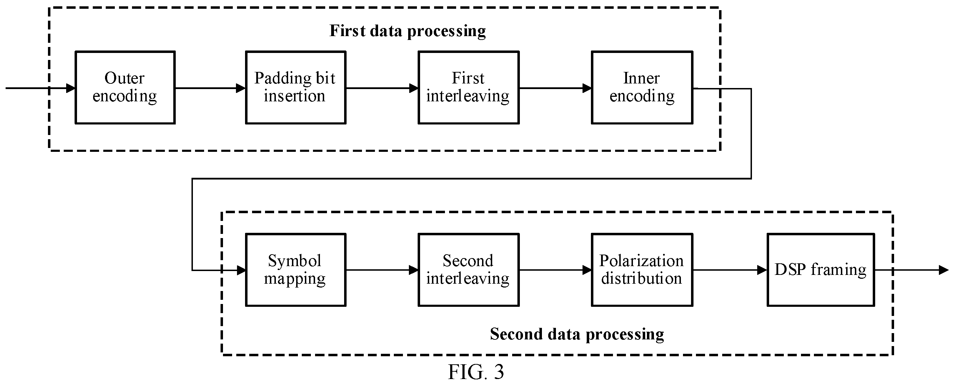

FIG. 3 is a diagram of an implementation of a transmitter data processor according to an embodiment of this application. As shown in FIG. 3, a transmitter data processor obtains to-be-encoded bit data from a received data sequence, performs first data processing including outer encoding, padding bit (padding bits) insertion, first interleaving, and inner encoding, to obtain data that is obtained through the outer encoding and the inner encoding, and then performs second data processing including symbol mapping (symbol map), second interleaving, polarization distribution (polarization distribution), and DSP framing (framing). In an example, after obtaining the to-be-encoded bit data, the transmitter data processor first performs the first data processing, to be specific, sequentially performs the outer encoding, the padding bit (padding bits) insertion, the first interleaving, and the inner encoding, to obtain the data that is obtained through the outer encoding and the inner encoding; and then performs the second data processing, to be specific, sequentially performs the symbol mapping (symbol map), the second interleaving, the polarization distribution (polarization distribution), and the DSP framing (framing).

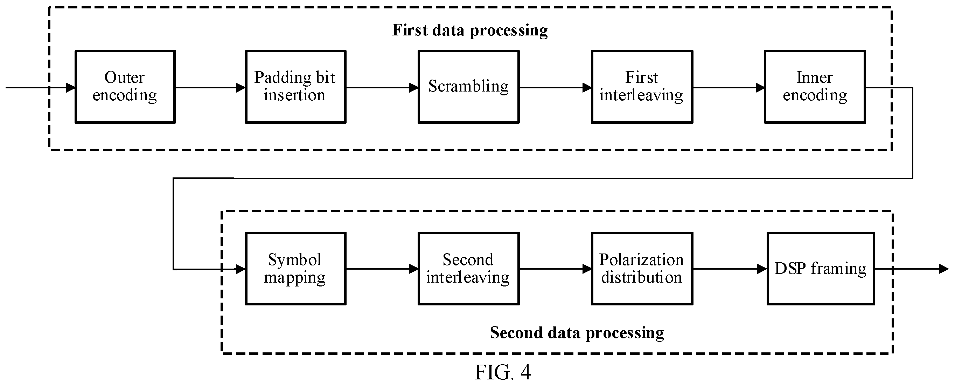

FIG. 4 is a diagram of another implementation of a transmitter data processor according to an embodiment of this application. It should be understood that, in actual application, operations performed by a transmitter data processor include but are not limited to the operations shown in FIG. 3. As shown in FIG. 4, before first interleaving processing is performed, outer encoded data that is obtained through outer encoding and padding bit insertion may be further scrambled (scramble). It should be noted that, for the data processing procedures described in FIG. 3 and FIG. 4, the second interleaving in the second data processing is interleaving performed after modulation symbol data is obtained through symbol mapping, and is also referred to as symbol interleaving (symbol interleave).

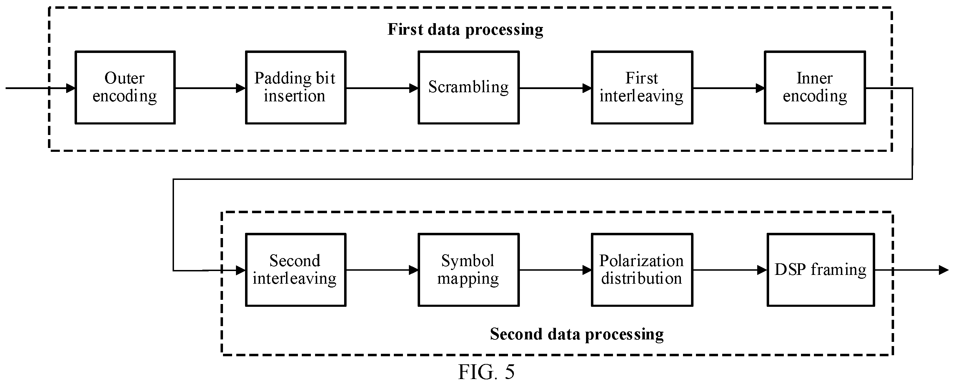

FIG. 5 is a diagram of still another implementation of a transmitter data processor according to an embodiment of this application. It should be understood that an execution sequence of the steps in the foregoing second data processing may alternatively be flexibly adjusted. As shown in FIG. 5, after obtaining to-be-encoded bit data, a transmitter data processor first performs first data processing, to be specific, sequentially performs outer encoding, padding bit (padding bits) insertion, scrambling (Scramble), first interleaving, and inner encoding, to obtain data that is obtained through the outer encoding and the inner encoding; and then performs second data processing, to be specific, sequentially performs second interleaving, symbol mapping (symbol map), polarization distribution (polarization distribution), and DSP framing (framing).

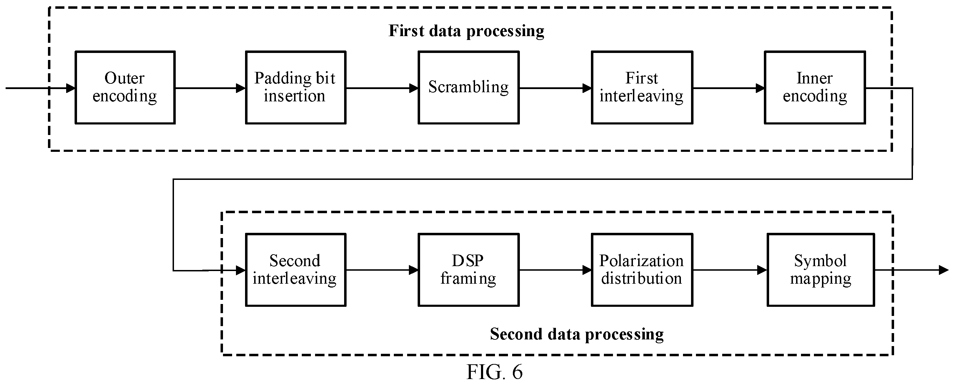

FIG. 6 is a diagram of yet another implementation of a transmitter data processor according to an embodiment of this application. As shown in FIG. 6, after obtaining to-be-encoded bit data, a transmitter data processor first performs first data processing, to be specific, sequentially performs outer encoding, padding bit (padding bits) insertion, scrambling (Scramble), first interleaving, and inner encoding, to obtain data that is obtained through the outer encoding and the inner encoding; and then performs second data processing, to be specific, sequentially performs second interleaving, DSP framing (framing), polarization distribution (polarization distribution), and symbol mapping (symbol map).

It should be noted that the DSP framing operation in FIG. 3, FIG. 4, and FIG. 5 is to insert at least one preset symbol (preset symbol) such as a pilot symbol (pilot symbol), a training symbol (training symbol), a frame alignment symbol (frame alignment symbol), and a reserved symbol (reserved symbol) into symbol data obtained through symbol mapping. A plurality of pilot symbols inserted in the DSP framing are used for carrier phase recovery, a plurality of training symbols are used for link training, and a plurality of frame alignment symbols are used for frame alignment to obtain a boundary of a DSP frame. A plurality of reserved symbols are reserved for other purposes in the future, and may be randomized, or some of the reserved symbols may be fixed for other purposes, for example, used for optical signal-to-noise ratio (optical signal-to-noise ratio, OSNR) measurement and end-to-end (E2E) latency measurement. In some specific applications, a DSP frame obtained through the DSP framing includes a plurality of subframes, and the DSP frame is also referred to as a super-frame (super-frame) or a multi-frame (multi-frame).

It should be further noted that the DSP framing operation in FIG. 3, FIG. 4, and FIG. 5 is performed on a symbol. Alternatively, in a manner shown in FIG. 6, DSP framing is performed, according to a used symbol mapping rule and before symbol mapping, on data obtained through second interleaving. For example, a bit corresponding to at least one preset symbol such as a pilot symbol, a training symbol, a frame alignment symbol, or a reserved symbol is inserted. Then, polarization distribution and symbol mapping are performed to obtain a DSP frame. The DSP frame is a same symbol as a DSP frame obtained by performing DSP framing on a symbol. It should be understood that another DSP framing (framing) manner is not excluded. Details are not described in this application.

It should be further noted that, in some possible scenarios, the first interleaving operation in FIG. 3 to FIG. 6 may be bypassed (bypass), that is, the first interleaving is an optional operation, so that the first data processing has a low latency.

It should be understood that the "inner" in an inner code and the "outer" in an outer code are distinguished based merely on a distance between a channel transmission medium and an execution body that performs an operation on data. An execution body that performs an operation on the inner code is closer to the channel transmission medium, and an execution body that performs an operation on the outer code is farther away from the channel transmission medium. In this embodiment of this application, FIG. 1 is used as an example. The transmitter processing module 02 sequentially encodes data twice and then sends the encoded data to the channel transmission medium. Therefore, data that is first encoded by the transmitter processing module 02 is farther away from the channel transmission medium, and data that is later encoded by the transmitter processing module 02 is closer to the channel transmission medium. In this way, the data that is first encoded by the transmitter processing module 02 is referred to as data obtained through the outer encoding, and the data that is later encoded by the transmitter processing module 02 is referred to as data obtained through the inner encoding. Correspondingly, data that is first decoded by the receiver processing module 04 is referred to as data obtained through inner decoding, and data that is later decoded by the receiver processing module 04 is referred to as data obtained through outer decoding. In a possible implementation, both the inner encoding and the outer encoding use an FEC encoding scheme, to form a concatenated FEC transmission scheme. For example, the transmitter processing module 02 may perform outer encoding by using a staircase (staircase, SC) code, and perform inner encoding by using a Hamming (Hamming) code or a Bose-Chaudhuri-Hocquenghem (Bose-Chaudhuri-Hocquenghem, BCH) code.

It should be noted that the foregoing content is example description of an application scenario of the data processing method provided in embodiments of this application, and does not constitute any limitation on application scenarios of the data processing method. A person of ordinary skill in the art may learn that, as a service requirement changes, the application scenario of the data processing method may be adjusted based on an application requirement. Application scenarios are not listed one by one in embodiments of this application. The following mainly describes a data processing method applied to a data transmitter. A data processing method applied to a receiver may be understood as an inverse operation of the data processing method of the transmitter. With the data processing method of the transmitter determined, the data processing method of the receiver is also clear. Therefore, the data processing method of the receiver is not described in detail in this application.

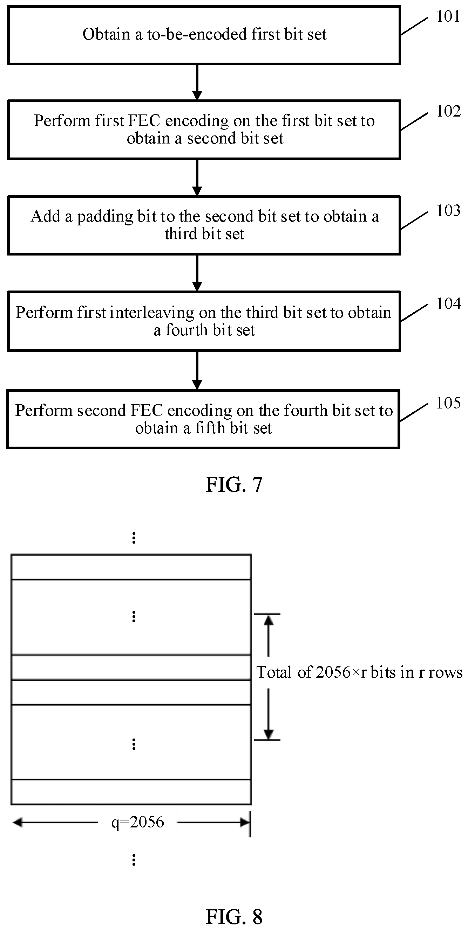

FIG. 7 is a schematic flowchart of a data processing method for optical communication according to an embodiment of this application. The data processing method includes the following steps, which are described in detail below. It should be understood that, for ease of description, first FEC encoding in the following may be considered as outer encoding described above, and second FEC encoding in the following may be considered as inner encoding described above. The following may be understood based on this.

101: Obtain a to-be-encoded first bit set.

FIG. 8 is a diagram of a first bit set according to an embodiment of this application. The first bit set may be obtained from a received data sequence, and the received data sequence may be represented as one lane of data streams, or may be represented in a form of a matrix, or may be represented by using a plurality of data frames. In an example, as shown in FIG. 8, the first bit set is represented in the form of the matrix, the first bit set includes a plurality of rows of bits, and each row includes q bits, where q is a positive integer. Optionally, q is an integer multiple of 257. Usually, an Ethernet data frame is obtained through encoding at a granularity of 257 bits, and q is an integer multiple of 257, which may better adapt to the Ethernet data frame. For example, q may be 2056, 4112, 8224, or 10280. A total of q × r bits are obtained by obtaining r rows from the received data sequence each time, in other words, the first bit set includes r rows and q columns of bits, that is, r × q bits, where r is a positive integer. It should be understood that, in this embodiment of this application, q=2056 is used as an example for description. To be specific, the first bit set includes d₁ bits, where d₁=r×2056, in other words, the d₁ bits are distributed in r rows and 2056 columns, and r=119×L, where L is a positive integer.

102: Perform first FEC encoding on the first bit set to obtain a second bit set.

The first FEC encoding is the outer encoding described above. Specifically, outer encoding is performed on every 244664 payload (payload) bits in the first bit set to obtain a total of 244664+32+6+16384=261086 encoded bits. In other words, every 261086 bits in the second bit set are obtained by performing outer encoding on every 244664 bits in the first bit set, the second bit set includes d₂ bits, and d₂=261086×L.The 261086 encoded bits include 32 first-type bits, six second-type bits, and 16384 check bits obtained through the outer encoding.

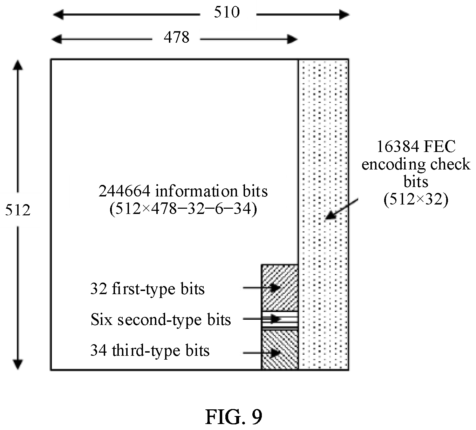

FIG. 9 is a diagram of bit distribution of outer encoding according to an embodiment of this application. As shown in FIG. 8, bits participating in outer encoding and check bits obtained through the outer encoding may be represented by using a matrix. In some specific applications, the 32 first-type bits are obtained by performing cyclic redundancy check (cyclic redundancy check, CRC) on the 244664 payload (payload) bits. Typically, the CRC uses CRC-32 check. In some other specific applications, the 32 first-type bits are 32 reserved bits, which are referred to as RES for short. The six second-type bits are a multi-group alignment signal (multi-block alignment signal, MBAS).

More specifically, a total of 244664+32+6+34=244736 bits, including 244664 payload (payload) bits, 32 first-type bits, six second-type bits, and 34 third-type bits, may be represented in 512 rows and 478 columns in FIG. 9. In some specific applications, the 34 third-type bits are all-zero bits. The 244736 bits are used as an encoding input of an SC code, so that 16384 FEC encoding check bits of the SC code may be obtained. It should be noted that the 16384 FEC encoding check bits of the SC code are combined with the 244736 bits, to obtain a total of 261120 bits, which are referred to as SC code codeword bits. The SC code codeword bits may be represented in 512 rows and 510 columns in FIG. 9, and are also referred to as an SC code codeword group (FEC block). The SC code uses convolutional encoding. When the 16384 FEC encoding check bits are generated through encoding, in addition to the 244736 bits, the 261120 SC code codeword bits at a previous moment further need to be used.

It should be noted that the 34 third-type bits participate in SC code encoding but are not transmitted or sent. Therefore, every 244664 payload (payload) bits in the first bit set are encoded through outer encoding to obtain 261120-34=261086 encoded bits, namely, 261086 bits in the second bit set. It should be further noted that an error decorrelator (error decorrelator, ED) operation is further performed in the SC code, so that an overall FEC scheme has a better anti-burst characteristic and better performance. The MBAS bits may be used for synchronization of an ED state (state).

In some specific applications, CRC-32 bits, six MBAS bits, and 34 all-zero bits (not transmitted) are inserted. Operations such as SC encoding and error decorrelation are also briefly referred to as SC-FEC adapt, ED&encoding (SC-FEC adapt, ED&Encoding), and are also referred to as first FEC encoding or outer encoding herein. It should be understood that a quantity of payload (payload) bits corresponding to the outer encoding is 244664=2056×119. Considering that the first bit set includes the r rows and 2056 columns of bits, r is selected as an integer multiple of 119, that is, r=119×L, so that a total of 261086×L encoded bits can be obtained by performing outer encoding L times on the first bit set including 2056×r bits, and is referred to as the second bit set.

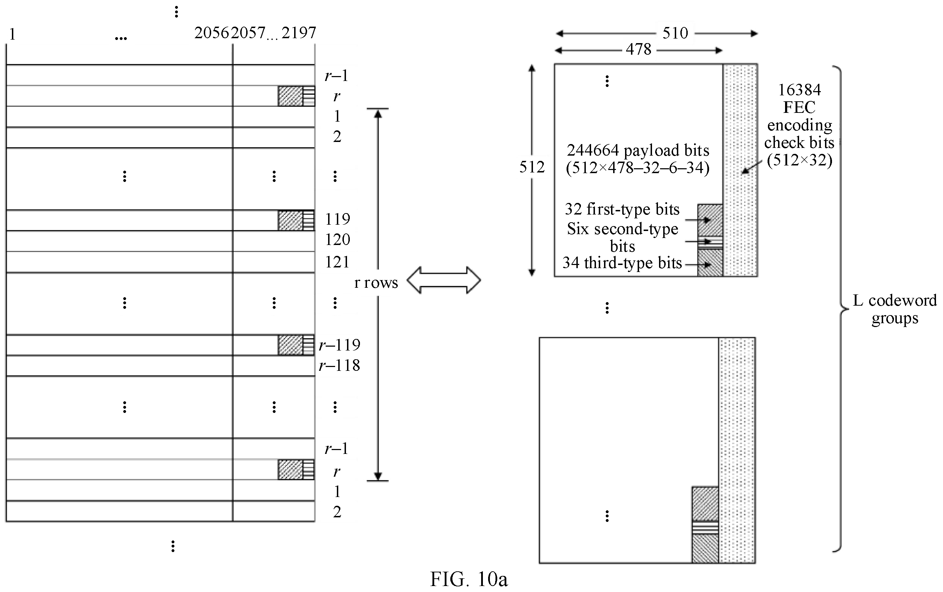

FIG. 10a is a diagram of a second bit set according to an embodiment of this application. As shown in FIG. 10a, the second bit set may be represented by using a multi-row matrix, where each row includes 2194 bits, and 2056 bits in each row are used to store payload bits, 138 bits in each row are used to store first-type bits, second-type bits, and FEC encoding check bits of an SC code. It should be noted that 34 third-type bits included in an SC code codeword group (FEC block) are not transmitted, that is, the third-type bits do not exist in the multi-row 2194-column matrix in FIG. 10a. It can be learned from FIG. 10a that a total of 2194×1 19=261086 bits in every 119 rows in the multi-row 2194-column matrix exactly carry a total of 261086 bits including 244664 payload (payload) bits, 32 first-type bits, six second-type bits, and 16384 FEC encoding check bits of an SC code, and a total of 2056×119=244664 bits in first 2056 columns in every 119 rows exactly carry the 244664 payload bits in the SC code. Therefore, this processing method has better data matching, so that hardware implementation is simple and complexity is low.

It should be understood that 244664 payload bits in one SC code codeword group are in 119 rows in the multi-row 2194-column matrix, and are in first 2056 columns in the 119 rows and 2194 columns, that is, columns 1 to 2056 in FIG. 10a. 16384 FEC encoding check bits of an SC code in one SC code codeword group are in a group of 119 rows in the multi-row 2194-column matrix, and are in last 138 columns in the 119 rows and 2194 columns, that is, columns 2057 to 2194 in FIG. 10a.

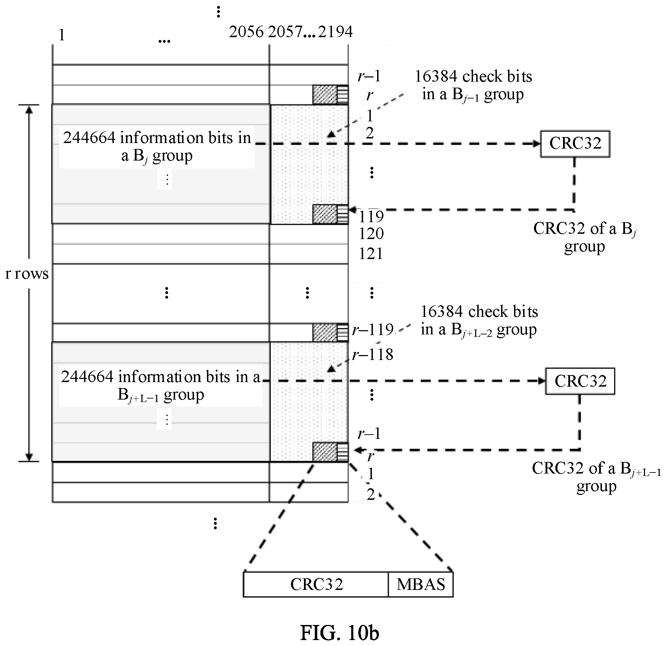

FIG. 10b is another diagram of a second bit set according to an embodiment of this application. It should be noted that 244664 payload bits and 16384 FEC encoding check bits of an SC code in one SC code codeword group are not necessarily carried in a same group of 119 rows. As shown in FIG. 10b, one group of 119 rows in a multi-row 2194-column matrix carries 244664 payload bits in one SC code codeword group B*ⱼ* and 16384 FEC encoding check bits of an SC code in a previous SC code codeword group B_{*j*-1} (namely, a codeword group obtained through encoding at a previous moment). For ease of description, it may be understood as that one group of 119 rows in the multi-row 2194-column matrix carries bits in one SC code codeword group. In addition, FIG. 10b also shows specific locations of CRC32 and MBAS bits in the multi-row 2194-column matrix.

103: Add a padding bit to the second bit set to obtain a third bit set.

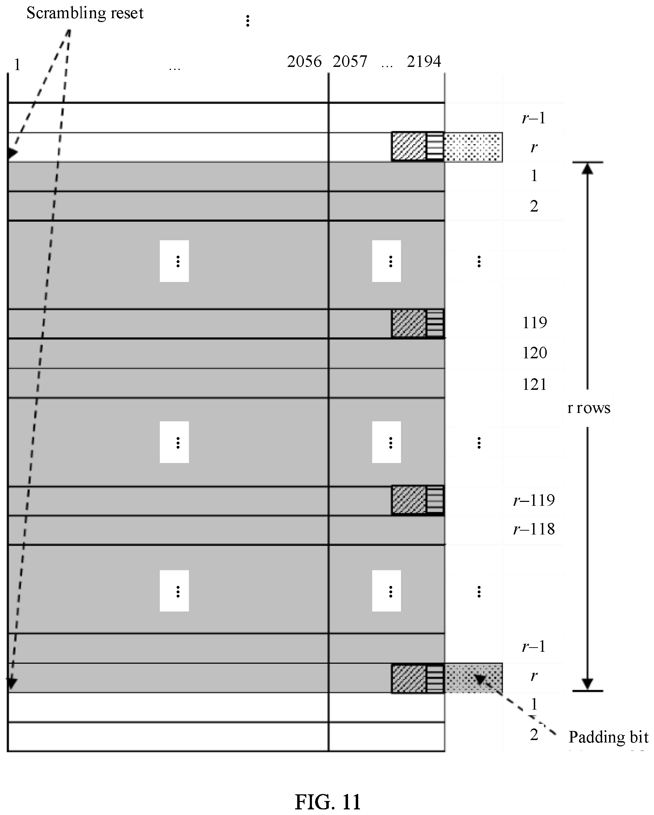

FIG. 11 is a diagram of a third bit set according to an embodiment of this application. As shown in FIG. 11, d_{pad} padding bits are added to a second bit set including 261086×L bits to obtain a third bit set, where the third bit set includes d₃ bits, d₃=261086×L+d_{pad}, and d_{pad} ≥ 0. Optionally, after the d_{pad} padding bits are added to the second bit set, 261086×L+d_{pad} bits obtained by adding the d_{pad} padding bits further need to be scrambled, so that 0s and 1s in scrambled bit data tend to have more equal probabilities, thereby achieving direct current balance, which facilitates receiving at a receiver. Usually, the d_{pad} padding bits are all-zero bits.

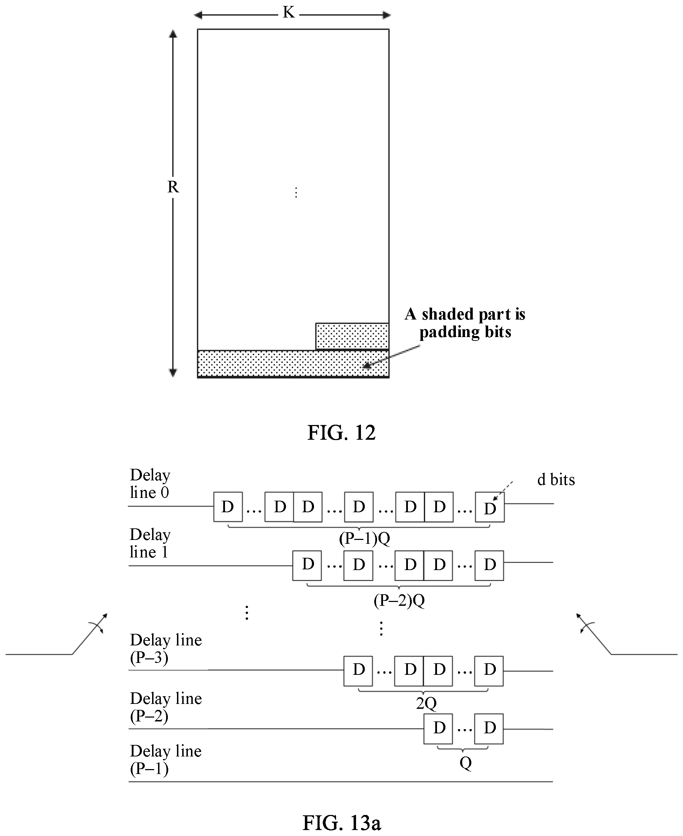

FIG. 12 is another diagram of a third bit set according to an embodiment of this application. In some possible scenarios, the third bit set is distributed in rows and columns. For example, the third bit set includes R rows and K columns of bits, that is, 261086×L+d_{pad}=R×K. It should be understood as that K may be understood as an information bit length for inner encoding (second FEC encoding). Herein, d_{pad} is not limited to an integer multiple of K. An appropriate value of d_{pad} is selected, so that a length of the third bit set is an integer multiple of the information bit length K for the inner encoding. This facilitates fast outer-code synchronization after inner-code synchronization, so that hardware implementation is simple, and complexity is low.

It should be noted that, in some specific application implementation scenarios, when d_{pad} = 0, it indicates that the padding bit insertion operation may be bypassed (bypass). In other words, the padding bit insertion operation in the data processing shown in FIG. 3, FIG. 4, FIG. 5, and FIG. 6 is optional (optional).

104: Perform first interleaving on the third bit set to obtain a fourth bit set.

In a possible implementation, the first interleaving is convolutional interleaving, and has low implementation complexity. Specifically, a fourth bit set may be obtained by performing convolutional interleaving on the third bit set. The fourth bit set includes d₄ bits, and d₄=d₃=261086×L+d_{pad}. The following describes a possible implementation of the convolutional interleaving.

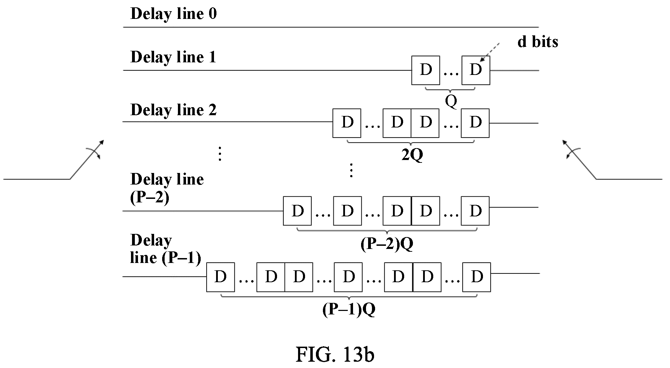

FIG. 13a is a diagram of a first implementation of convolutional interleaving according to an embodiment of this application. FIG. 13b is a diagram of a second implementation of convolutional interleaving according to an embodiment of this application. As shown in FIG. 13a and FIG. 13b, a convolutional interleaver includes P delay lines (delay line), and the convolutional interleaver delays input data in a third bit set based on the P delay lines, to obtain a fourth bit set. P is an integer greater than 1, a quantity of storage units included in each delay line is different, a delay line having a smallest quantity of storage units includes zero storage units, a difference between quantities of storage units in every two adjacent delay lines is Q, and each storage unit is configured to store d bits. Bits in the third bit set are sequentially input into the P delay lines based on sequence numbers of the P delay lines, each delay line receives d bits per input and outputs d bits per output, P×d consecutive bits output through convolutional interleaving include the d bits output from each delay line. Q is an integer greater than or equal to 1, and d is an integer greater than or equal to 1. For example, the P delay lines respectively include zero storage units, Q storage units, 2Q storage units, ..., (P-1) Q storage units, and each storage unit is configured to store d bits. In this case, the P delay lines respectively correspond to P delay values, and the delay values include 0 bits, Q×d bits, 2Q×d bits, ..., (P-1) Q×d bits, which may also be understood as that an interleaving depth of the convolutional interleaver is P. It should be noted that, in this application, the delay value is measured in bits. A larger quantity of bits included in the delay value of the delay line indicates a longer delay (also referred to as latency) of the delay line for data. It should be understood that, when the delay line includes no storage unit, a delay caused by the delay line is 0 bits, that is, transparent transmission without a delay is performed.

As shown in FIG. 13a, quantities of storage units in the P delay lines sequentially decrease based on the sequence numbers of the P delay lines. To be specific, a delay line 0 has (P-1)Q storage units, Q storage units are sequentially decreased for each delay line, and a delay line (P-1) has zero storage units. As shown in FIG. 13b, quantities of storage units in the P delay lines sequentially increase based on the sequence numbers of the P delay lines. To be specific, a delay line 0 has zero storage units, Q storage units are sequentially increased for each delay line, and a delay line (P-1) has (P-1)Q storage units.

It should be noted that, at a same moment, a switch (switch) for input and output of the convolutional interleaver is on a same delay line. After a current delay line receives d bits per input and outputs d bits per output, positions of the switches are updated to a next delay line, to ensure that the bits in the first bit set are sequentially input into the P delay lines based on the sequence numbers of the P delay lines, and the P×d consecutive bits output through convolutional interleaving include the d bits output from each delay line. A specific data read/write operation performed by the convolutional interleaver is as follows: d bits are read from a storage unit that is closest to an output port and that is on the current delay line. d bits stored in each storage unit that is on the current delay line are transferred to a next storage unit. Next, d bits are written into a storage unit that is closest to an input port and that is on the current delay line. Then, switching to a next delay line is performed, and the foregoing operations are repeated. The rest can be deduced by analogy.

It should be understood that when same parameters P, Q, and d are used, convolutional interleaving in FIG. 13a and convolutional interleaving in FIG. 13b are inverse operations of each other. In other words, when a transmitter processing module uses a convolutional interleaving structure shown in FIG. 13a, convolutional de-interleaving corresponding to a receiver processing module that corresponds to the transmitter processing module uses a structure shown in FIG. 13b. Similarly, when a transmitter processing module uses a convolutional interleaving structure shown in FIG. 13b, convolutional de-interleaving corresponding to a receiver processing module that corresponds to the transmitter processing module uses a structure shown in FIG. 13a.

The third bit set shown in FIG. 12 is used as an example. The fourth bit set also includes R rows and K columns of bits. In a possible scenario, K is an integer multiple of d, P×d is an integer multiple of K, and $R \times \frac{K}{d}$ is an integer multiple of P. In this case, K bits in each row in the fourth bit set are K bits output from $\frac{K}{d}$ delay lines in the convolutional interleaver. In this manner, before the convolutional interleaving is performed on data in the third bit set, a switch for input and output of the convolutional interleaver is initialized to a delay line 0. After all the data in the third bit set is input into the convolutional interleaver, the switch for input and output of the convolutional interleaver returns to the delay line 0. This facilitates synchronization of a de-convolutional interleaver at a receiver, so that hardware implementation is simple. Typically, K=d, and R is an integer multiple of P, so that a data processing procedure is simpler, and hardware implementation complexity is low.

In some specific embodiments, the convolutional interleaver includes P=16 delay lines, a difference between two adjacent delay lines is Q=2 storage units, and each storage unit includes d=K bits.

105: Perform second FEC encoding on the fourth bit set to obtain a fifth bit set.

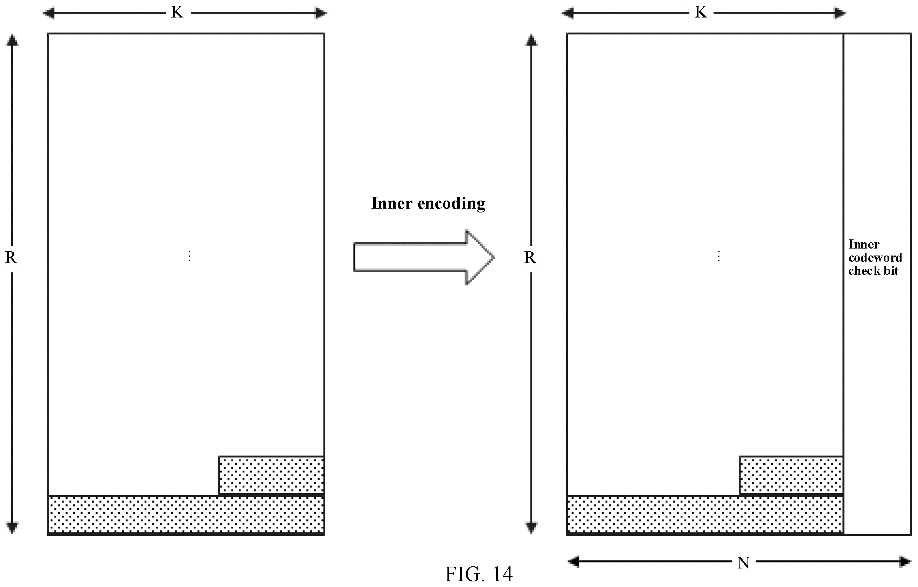

FIG. 14 is a diagram of an implementation of performing inner encoding on a fourth bit set according to an embodiment of this application. As shown in FIG. 14, a fifth bit set includes R codewords that undergo inner encoding, and each codeword includes K information bits and N-K check bits, totaling N bits. A total of d₅=R×N bits are included. An example in which a fourth bit set includes R rows and K columns of bits is used. The fifth bit set obtained by performing inner encoding on the fourth bit set includes R rows and N columns of bits. N bits in each row in the fifth bit set may be considered as one inner codeword.

It should be noted that an appropriate quantity d_{pad} of padding bits is selected, so that the third bit set into which the d_{pad} padding bits are inserted presents row-column distribution shown in FIG. 12, that is, 261086×L+d_{pad}=R×K. In this case, a quantity of bits included in a third data set is an integer quantity K of information bits. This facilitates fast outer-code synchronization after inner-code synchronization, so that hardware implementation is simple, and complexity is low.

In a possible implementation, the inner encoding in this embodiment of this application may specifically use BCH encoding or extended BCH encoding with at least 2-bit error correction over GF(2^{m}). Typically, when a length of an inner codeword remains unchanged or slightly decreases, an error correction capability of the inner codeword is improved to 2 bits, so that performance of cascaded encoding is improved, but complexity remains low. GF refers to a finite field, and may also be referred to as a Galois field (Galois field), and 2^{m} represents an order of the finite field.

The following provides several possible inner encoding schemes, where N represents a length of an inner codeword, and K represents a length of an information bit in the inner codeword. An order of a finite field used in the inner encoding schemes is low, for ease of implementation of hardware.
(1) The length of the inner codeword is 127 bits, and an inner code information length is 113 bits, for example, BCH (127, 113).
(2) The length of the inner codeword is 128 bits, and an inner code information length is 113 bits, for example, BCH (128, 113).
(3) The length of the inner codeword is 128 bits, and an inner code information length is 112 bits, for example, BCH (128, 112).
(4) The length of the inner codeword is 126 bits, and an inner code information length is 110 bits, for example, BCH (126, 110).
(5) The length of the inner codeword is 136 bits, and an inner code information length is 119 bits, for example, BCH (136, 119).
(6) The length of the inner codeword is 135 bits, and an inner code information length is 119 bits, for example, BCH (135, 119).

It should be noted that, after the fifth bit set is obtained through inner encoding, second data processing further needs to be performed, that is, operations including symbol mapping (symbol map), second interleaving, polarization distribution (Polarization distribution), DSP framing (framing), and the like are performed. For understanding, refer to FIG. 3, FIG. 4, FIG. 5, and FIG. 6. A symbol mapping manner includes but is not limited to quadrature phase shift keying (quadrature phase shift keying, QPSK) and quadrature amplitude modulation (quadrature amplitude modulation, QAM). Specifically, the symbol mapping is performed on t bits to obtain a dual-polarization (dual-polarization, DP) symbol, for example, a DP-QPSK, DP-8QAM, DP-16QAM, DP-32QAM, and DP-64QAM symbol. Typically, when t=4, the dual-polarization symbol is the DP-QPSK symbol. When t=8, the dual-polarization symbol is the DP-16QAM symbol. The fifth bit set of d₅=(261086×L+d_{pad}/K×N bits corresponds to d₅/t dual-polarization symbols. Typically, the d₅/t dual-polarization symbols correspond to one DSP frame after the DSP framing. In other words, one DSP frame is obtained by performing data processing on the first bit set with the total of 2056×r bits in the r rows that is obtained from the received data sequence, so that implementation is simple and complexity is low. Herein, the d₅/t dual-polarization symbols are also referred to as symbols before the DSP framing.

It should be noted that, for DP-16QAM modulation, a first bit set including f_{DP-16QAM} rows and 2056 columns of bits is obtained from the received data sequence. For DP-QPSK modulation, a first bit set including r_{DP-QPSK} rows and 2056 columns of bits is obtained from the received data sequence. When r_{DP-16QAM} = 2 × r_{DP-QPSK}, the appropriate value of the quantity d_{pad} of padding bits is selected, so that a quantity of modulation symbols using DP-16QAM can be equal to a quantity of modulation symbols using the DP-QPSK modulation, thereby ensuring that structures of DSP frames obtained through the second data processing are the same. In other words, this data processing manner can be better compatible with the DP-16QAM and DP-QPSK modulation.

The following provides several specific embodiments with reference to several different implementations of inner encoding.

Embodiment 1: Inner encoding uses (127, 113) encoding. To be specific, a length of an inner codeword is N=127 bits, and an inner code information length is K=113 bits.

For example, an inner code uses BCH (127, 113), and is a BCH (127, 113) code that is constructed over a finite field GF(2⁷) with 2-bit error correction.

A received data sequence includes a plurality of rows of bits, and each row includes q=2056 bits. A first bit set of a total of 2056×r bits in r rows and q=2056 columns of bits is obtained from the received data sequence. A quantity r of rows is an integer multiple of 119, that is, r=119×L, where L is a positive integer.

Outer encoding (First FEC encoding) is performed L times on the first bit set including 2056×r=2056×119×L=244664×L bits, where every 244664 bits in the first bit set are encoded to obtain a total of 261086 encoded bits, and a total of 261086×L encoded bits are obtained, and are referred to as the second bit set. Herein, L is also referred to as a quantity of SC code codeword groups.

d_{pad} padding bits are added to the second bit set including 261086×L bits, to obtain a third bit set of 261086×L+d_{pad} bits. Optionally, the 261086×L+d_{pad} bits are further scrambled, so that 0s and 1s in scrambled bit data tend to have more equal probabilities, thereby achieving direct current balance, which facilitates receiving at a receiver.

Next, convolutional interleaving is performed on the third bit set to obtain a fourth bit set whose length is 261086×L+d_{pad} bits. A convolutional interleaver includes P=16 delay lines, a difference between two adjacent delay lines is Q=2 storage units, and each storage unit includes d=K bits. In addition, 261086×L+d_{pad}=R×K.

Then, every K=113 bits in the fourth bit set are encoded to obtain N=127 inner codeword bits, so as to obtain a fifth bit set of a total of d₅=R×N=(261086×L+d_{pad})/K×N=(261086×L+d_{pad})/113×127 bits. In addition, second data processing including symbol mapping and polarization distribution is performed.

When DP-16QAM is used for the symbol mapping, a quantity of DP-16QAM symbols corresponding to the fifth bit set of d₅ =(261086×L+ d_{pad} )/K×N bits is s_{DP-16QAM} = d₅/ 8=(261086×L+d_{pad})/K×N/8=(261086×L+d_{pad})/113×127/8, where L=r/119.

When DP-QPSK is used for the symbol mapping, a quantity of DP-QPSK symbols corresponding to the fifth bit set of d₅ =(261086×L+ d_{pad} )/K×N bits is s_{DP-QPSK} = d₅/ 4=(261086×L+d_{pad})/K×N/4=(261086×L+d_{pad})/113×127/4, where L=r/119.

The following table provides some parameter combinations, including the quantity r of rows, the quantity d_{pad} of padding bits, the quantity d₅ of bits in the fifth bit set, the quantity s_{DP-16QAM} of DP-16QAM symbols corresponding to the fifth bit set, and the quantity s_{DP-QPSK} of DP-QPSK symbols corresponding to the fifth bit set.

**Table 1**

| Sequence number | r | d_{pad} | d₅ | s_{DP-16QAM} | s_{DP-QPSK} |
|---|---|---|---|---|---|
| 1 | 119 | 1074 | 294640 | 36830 | 73660 |
| 2 | 238 | 340 | 587248 | 73406 | 146812 |
| 3 | 357 | 1414 | 881888 | 110236 | 220472 |
| 4 | 476 | 680 | 1174496 | 146812 | 293624 |
| 5 | 595 | 1754 | 1469136 | 183642 | 367284 |
| 6 | 714 | 1020 | 1761744 | 220218 | 440436 |
| 7 | 833 | 286 | 2054352 | 256794 | 513588 |
| 8 | 952 | 1360 | 2348992 | 293624 | 587248 |
| 9 | 1071 | 626 | 2641600 | 330200 | 660400 |
| 10 | 1190 | 1700 | 2936240 | 367030 | 734060 |
| 11 | 1309 | 966 | 3228848 | 403606 | 807212 |
| 12 | 1428 | 232 | 3521456 | 440182 | 880364 |
| 13 | 1547 | 1306 | 3816096 | 477012 | 954024 |
| 14 | 1666 | 572 | 4108704 | 513588 | 1027176 |
| 15 | 1785 | 1646 | 4403344 | 550418 | 1100836 |
| 16 | 1904 | 912 | 4695952 | 586994 | 1173988 |
| 17 | 2023 | 178 | 4988560 | 623570 | 1247140 |
| 18 | 2142 | 1252 | 5283200 | 660400 | 1320800 |
| 19 | 2261 | 518 | 5575808 | 696976 | 1393952 |
| 20 | 2380 | 1592 | 5870448 | 733806 | 1467612 |

It should be noted that a larger value of the quantity r of rows indicates a larger quantity of dual-polarization symbols corresponding to the fifth bit set, resulting in higher complexity; but the larger quantity of dual-polarization symbols indicates lower framing redundancy introduced in DSP framing. The appropriate quantity r of rows may be selected based on different scenario requirements, to implement an effective compromise between complexity and framing redundancy.

A quantity of rows in a first bit set in a DP-16QAM modulation scenario is represented as r_{DP-16QAM}, and a quantity of rows in a first bit set in a DP-QPSK modulation scenario is represented as r_{DP-QPSK}. To make used data processing better compatible with the DP-16QAM and DP-QPSK modulation, r_{DP-16QAM} may be selected as twice r_{DP-QPSK}. In this case, s_{DP-16QAM} = s_{DP-QPSK}, so that structures of DSP frames obtained through the second data processing are the same. The following table lists corresponding parameter combinations.

**Table 2**

| Sequence number | Modulation format | r | d_{pad} | d₅ | s_{DP-16QAM} | s_{DP-QPSK} |
|---|---|---|---|---|---|---|
| 1 | DP-QPSK | 476 | 680 | 1174496 | | 293624 |
| | DP-16QAM | 952 | 1360 | 2348992 | 293624 | |
| 2 | DP-QPSK | 833 | 286 | 2054352 | | 513588 |
| | DP-16QAM | 1666 | 572 | 4108704 | 513588 | |
| 3 | DP-QPSK | 1071 | 626 | 2641600 | | 660400 |
| | DP-16QAM | 2142 | 1252 | 5283200 | 660400 | |

In an example, in a scenario using DP-QPSK symbol mapping, a quantity of rows is r_{DP-QPSK} = 476, and a quantity of padding bits is d_{pad}=680. As shown in FIG. 8, the first bit set includes the r_{DP-QPSK} = 476 rows and q=2056 columns of bits, the convolutional interleaver includes the P=16 delay lines, the difference between the two adjacent delay lines is the Q=2 storage units, and each storage unit includes the d=K=113 bits. A quantity of fifth bit sets obtained through the first data processing is d₅ = 1174496, and a quantity of DP-QPSK symbols corresponding to the fifth bit set is ${s}_{DP - QPSK} = \frac{{d}_{5}}{4} = 293624$.

In another example, in a scenario using DP-16QAM symbol mapping, a quantity of rows is r_{DP-16QAM} = 952, and a quantity of padding bits is d_{pad}=1360. As shown in FIG. 8, the first bit set includes the r_{DP-16QAM} = 952 rows and q=2056 columns of bits, the convolutional interleaver includes the P=16 delay lines, the difference between the two adjacent delay lines is the Q=2 storage units, and each storage unit includes the d=K=113 bits. A quantity of fifth bit sets obtained through the first data processing is d₅ = 2348992, and a quantity of DP-16QAM symbols corresponding to the fifth bit set is ${s}_{DP - 16 QAM} = \frac{{d}_{5}}{8} = 293624$.

Embodiment 2: Inner encoding uses (128, 113) encoding. To be specific, a length of an inner codeword is N=128 bits, and an inner code information length is K=113 bits.

For example, an inner code uses BCH (128, 113), and is obtained by performing single-bit extension on a BCH (127, 113) code that is constructed over a finite field GF(2⁷) with 2-bit error correction, and therefore, may also be denoted as a single-bit extended E-BCH (128, 113). The inner code has a better error correction resistance capability, and has better performance than that of the inner code BCH (127, 113) in Embodiment 1.

A received data sequence includes a plurality of rows of bits, and each row includes q=2056 bits. A first bit set of a total of 2056×r bits in r rows and q=2056 columns of bits is obtained from the received data sequence. r is an integer multiple of 119, that is, r=119×L, where L is a positive integer.

Outer encoding (First FEC encoding) is performed L times on the first bit set including 2056×r⁻⁻2056×119×L=244664×L bits, where every 244664 bits in the first bit set are encoded to obtain a total of 261086 encoded bits, and a total of 261086×L encoded bits are obtained, and are referred to as the second bit set. Herein, L is also referred to as a quantity of SC code codeword groups.

d_{pad} padding bits are added to the second bit set including 261086×L bits, to obtain a third bit set including 261086×L+d_{pad} bits. Optionally, the 261086×L+d_{pad} bits are further scrambled, so that 0s and 1s in scrambled bit data tend to have more equal probabilities, thereby achieving direct current balance, which facilitates receiving at a receiver.

Next, convolutional interleaving is performed on the third bit set to obtain a fourth bit set whose length is 261086×L+d_{pad} bits. A convolutional interleaver includes P=16 delay lines, a difference between two adjacent delay lines is Q=2 storage units, and each storage unit includes d=K bits. In addition, 261086×L+d_{pad}=R×K.

Then, inner encoding is performed on every K=113 bits in the fourth bit set to obtain N=128 inner codeword bits, so as to a fifth bit set of a total of d₅=R×N=(261086×L+d_{pad})/K×N=(261086×L+d_{pad})/113×128 bits. In addition, second data processing including symbol mapping and polarization distribution is performed.

When DP-16QAM is used for the symbol mapping, a quantity of DP-16QAM symbols corresponding to the fifth bit set of d₅ =(261086×L+ d_{pad} )/K×N bits is s_{DP-16QAM} = d₅/ 8=(261086×L+d_{pad})/K×N/8=(261086×L+d_{pad})/113×128/8=(261086×L+d_{pad})/113×16, where L=r/119.

When DP-QPSK is used for the symbol mapping, a quantity of DP-QPSK symbols corresponding to the fifth bit set of d₅ =(261086×L+ d_{pad} )/K×N bits is s_{DP-QPSK} = d₅/ 4=(261086×L+d_{pad})/K×N/4=(261086×L+d_{pad})/113×128/4=(261086×L+d_{pad})/113×32, where L=r/119.

The following table provides some parameter combinations, including the quantity r of rows, the quantity d_{pad} of padding bits, the quantity d₅ of bits in the fifth bit set, the quantity s_{DP-16QAM} of DP-16QAM symbols corresponding to the fifth bit set, and the quantity s_{DP-QPSK} of DP-QPSK symbols corresponding to the fifth bit set.

**Table 3**

| Sequence number | r | d_{pad} | d₅ | s_{DP-16QAM} | s_{DP-QPSK} |
|---|---|---|---|---|---|
| 1 | 119 | 1074 | 296960 | 37120 | 74240 |
| 2 | 238 | 340 | 591872 | 73984 | 147968 |
| 3 | 357 | 1414 | 888832 | 111104 | 222208 |
| 4 | 476 | 680 | 1183744 | 147968 | 295936 |
| 5 | 595 | 1754 | 1480704 | 185088 | 370176 |
| 6 | 714 | 1020 | 1775616 | 221952 | 443904 |
| 7 | 833 | 286 | 2070528 | 258816 | 517632 |
| 8 | 952 | 1360 | 2367488 | 295936 | 591872 |
| 9 | 1071 | 626 | 2662400 | 332800 | 665600 |
| 10 | 1190 | 1700 | 2959360 | 369920 | 739840 |
| 11 | 1309 | 966 | 3254272 | 406784 | 813568 |
| 12 | 1428 | 232 | 3549184 | 443648 | 887296 |
| 13 | 1547 | 1306 | 3846144 | 480768 | 961536 |
| 14 | 1666 | 572 | 4141056 | 517632 | 1035264 |
| 15 | 1785 | 1646 | 4438016 | 554752 | 1109504 |
| 16 | 1904 | 912 | 4732928 | 591616 | 1183232 |
| 17 | 2023 | 178 | 5027840 | 628480 | 1256960 |
| 18 | 2142 | 1252 | 5324800 | 665600 | 1331200 |
| 19 | 2261 | 518 | 5619712 | 702464 | 1404928 |
| 20 | 2380 | 1592 | 5916672 | 739584 | 1479168 |

It should be noted that a larger value of the quantity r of rows indicates a larger quantity of dual-polarization symbols corresponding to the fifth bit set, resulting in higher complexity; but the larger quantity of dual-polarization symbols indicates lower framing redundancy introduced in DSP framing. The appropriate quantity r of rows may be selected based on different scenario requirements, to implement an effective compromise between complexity and framing redundancy.

A quantity of rows in a first bit set in a DP-16QAM modulation scenario is represented as r_{DP-16QAM}, and a quantity of rows in a first bit set in a DP-QPSK modulation scenario is represented as r_{DP-QPSK}. To make used data processing better compatible with the DP-16QAM and DP-QPSK modulation, r_{DP-16QAM} may be selected as twice r_{DP-QPSK}. In this case, s_{DP-16QAM} = s_{DP-QPSK}, so that structures of DSP frames obtained through the second data processing are the same. The following table lists corresponding parameter combinations.

**Table 4**

| Sequence number | Modulation format | r | d_{pad} | d₅ | s_{DP-16QAM} | s_{DP-QPSK} |
|---|---|---|---|---|---|---|
| 1 | DP-QPSK | 238 | 340 | 591872 | | 147968 |
| | DP-16QAM | 476 | 680 | 1183744 | 147968 | |
| 2 | DP-QPSK | 476 | 680 | 1183744 | | 295936 |
| | DP-16QAM | 952 | 1360 | 2367488 | 295936 | |
| 3 | DP-QPSK | 833 | 286 | 2070528 | | 517632 |
| | DP-16QAM | 1666 | 572 | 4141056 | 517632 | |

In an example, in a scenario using DP-QPSK symbol mapping, a quantity of rows is r_{DP-QPSK} = 238, and a quantity of padding bits is d_{pad}=340. As shown in FIG. 8, the first bit set includes the r_{DP-QPSK} = 238 rows and q=2056 columns of bits, the convolutional interleaver includes the P=16 delay lines, the difference between the two adjacent delay lines is the Q=2 storage units, and each storage unit includes the d=K=112 bits. A quantity of fifth bit sets obtained through the first data processing is d₅ = 591872 , and a quantity of DP-QPSK symbols corresponding to the fifth bit set is ${s}_{DP - QPSK} = \frac{{d}_{5}}{4} = 147968$.

In another example, in a scenario using DP-16QAM symbol mapping, a quantity of rows is r_{DP-16QAM} = 476, and a quantity of padding bits is d_{pad}=680. As shown in FIG. 8, the first bit set includes the r_{DP-QPSK} = 476 rows and q=2056 columns of bits, the convolutional interleaver includes the P=16 delay lines, the difference between the two adjacent delay lines is the Q=2 storage units, and each storage unit includes the d=K=112 bits. A quantity of fifth bit sets obtained through the first data processing is d₅ = 1183744, and a quantity of DP-16QAM symbols corresponding to the fifth bit set is ${s}_{DP - 16 QAM} = \frac{{d}_{5}}{8} = 147968$.

Embodiment 3: Inner encoding uses (128, 112) encoding. To be specific, a length of an inner codeword is N=128 bits, and an inner code information length is K=112 bits.

For example, an inner code uses BCH (128, 112), is obtained by performing double-bit extension on a BCH (127, 113) code that is constructed over a finite field GF(2⁷) with 2-bit error correction, and therefore may also be denoted as double-bit extended DE-BCH (128, 112). The inner code has a better error correction resistance capability, and has better performance than that of the inner code BCH (127, 113) in Embodiment 1 and that of the BCH (128, 113) in Embodiment 2. In some specific application embodiments, the inner code BCH (128, 112) may alternatively be obtained by first shortening the BCH (127, 113) by one bit to obtain BCH (126, 112), and then adding 2 bits for extension to obtain the double-bit extended DE-BCH (128, 112). This is not specifically limited herein.

A received data sequence includes a plurality of rows of bits, and each row includes q=2056 bits. A first bit set of a total of 2056×r bits in r rows and q=2056 columns of bits is obtained from the received data sequence. r is an integer multiple of 119, that is, r=119×L, where L is a positive integer.

Outer encoding (First FEC encoding) is performed L times on the first bit set including 2056×r=2056×119×L=244664×L bits, where every 244664 bits in the first bit set are encoded to obtain a total of 261086 encoded bits, and a total of 261086×L encoded bits are obtained, and are referred to as the second bit set. Herein, L is also referred to as a quantity of SC code codeword groups.

d_{pad} padding bits are added to the second bit set including 261086×L bits, to obtain a third bit set of 261086×L+d_{pad} bits. Optionally, the 261086×L+d_{pad} bits are further scrambled, so that 0s and 1s in scrambled bit data tend to have more equal probabilities, thereby achieving direct current balance, which facilitates receiving at a receiver.

Next, convolutional interleaving is performed on the third bit set to obtain a fourth bit set whose length is 261086×L+d_{pad} bits. A convolutional interleaver includes P=16 delay lines, a difference between two adjacent delay lines is Q=2 storage units, and each storage unit includes d=K bits. In addition, 261086×L+d_{pad}=R×K.

Then, inner encoding is performed on every K=112 bits in the fourth bit set to obtain N=128 inner codeword bits, so as to a fifth bit set of a total of d₅ =R×N=(261086×L+d_{pad} )/K×N=(261086×L+d_{pad} )/112×128 bits. In addition, second data processing including symbol mapping and polarization distribution is performed.

When DP-16QAM is used for the symbol mapping, a quantity of DP-16QAM symbols corresponding to the fifth bit set of d₅ =(261086×L+ d_{pad} )/K×N bits is s_{DP-16QAM} = d₅/ 8=(261086×L+d_{pad})/K×N/8=(261086×L+d_{pad})/112×128/8=(261086×L+d_{pad})/7, where L=r/119.

When DP-QPSK is used for symbol mapping, a quantity of DP-QPSK symbols corresponding to the fifth bit set of d₅ =(261086×L+ d_{pad} )/K×N bits is s_{DP-QPSK} = d₅/ 4 =(261086×L+ d_{pad} )/K×N/4=(261086×L+ d_{pad} )/112×128/4=(261086×L+ d_{pad} )/7×2, where L=r/119.

The following table provides some parameter combinations, including the quantity r of rows, the quantity d_{pad} of padding bits, the quantity d₅ of bits in the fifth bit set, the quantity s_{DP-16QAM} of DP-16QAM symbols corresponding to the fifth bit set, and the quantity s_{DP-QPSK} of DP-QPSK symbols corresponding to the fifth bit set.

**Table 5**

| Sequence number | r | d_{pad} | d₅ | s_{DP-16QAM} | s_{DP-QPSK} |
|---|---|---|---|---|---|
| 1 | 119 | 546 | 299008 | 37376 | 74752 |
| 2 | 238 | 1092 | 598016 | 74752 | 149504 |
| 3 | 357 | 1638 | 897024 | 112128 | 224256 |
| 4 | 476 | 392 | 1193984 | 149248 | 298496 |
| 5 | 595 | 938 | 1492992 | 186624 | 373248 |
| 6 | 714 | 1484 | 1792000 | 224000 | 448000 |
| 7 | 833 | 238 | 2088960 | 261120 | 522240 |
| 8 | 952 | 784 | 2387968 | 298496 | 596992 |
| 9 | 1071 | 1330 | 2686976 | 335872 | 671744 |
| 10 | 1190 | 84 | 2983936 | 372992 | 745984 |
| 11 | 1309 | 630 | 3282944 | 410368 | 820736 |
| 12 | 1428 | 1176 | 3581952 | 447744 | 895488 |
| 13 | 1547 | 1722 | 3880960 | 485120 | 970240 |
| 14 | 1666 | 476 | 4177920 | 522240 | 1044480 |
| 15 | 1785 | 1022 | 4476928 | 559616 | 1119232 |
| 16 | 1904 | 1568 | 4775936 | 596992 | 1193984 |
| 17 | 2023 | 322 | 5072896 | 634112 | 1268224 |
| 18 | 2142 | 868 | 5371904 | 671488 | 1342976 |
| 19 | 2261 | 1414 | 5670912 | 708864 | 1417728 |
| 20 | 2380 | 168 | 5967872 | 745984 | 1491968 |

It should be noted that a larger value of the quantity r of rows indicates a larger quantity of dual-polarization symbols corresponding to the fifth bit set, resulting in higher complexity; but the larger quantity of dual-polarization symbols indicates lower framing redundancy introduced in DSP framing. The appropriate quantity r of rows may be selected based on different scenario requirements, to implement an effective compromise between complexity and framing redundancy.

A quantity of rows in a first bit set in a DP-16QAM modulation scenario is represented as r_{DP-16QAM}, and a quantity of rows in a first bit set in a DP-QPSK modulation scenario is represented as r_{DP-QPSK}. To make used data processing better compatible with the DP-16QAM and DP-QPSK modulation, r_{DP-16QAM} may be selected as twice r_{DP-QPSK}. In this case, s_{DP-16QAM} = s_{DP-QPSK}, so that structures of DSP frames obtained through the second data processing are the same. The following table lists corresponding parameter combinations.

**Table 6**

| Sequence number | Modulation format | r | d_{pad} | d₅ | s_{DP-16QAM} | s_{DP-QPSK} |
|---|---|---|---|---|---|---|
| 1 | DP-QPSK | 119 | 546 | 299008 | | 74752 |
| | DP-16QAM | 238 | 1092 | 598016 | 74752 | |
| 2 | DP-QPSK | 476 | 392 | 1193984 | | 298496 |
| | DP-16QAM | 952 | 784 | 2387968 | 298496 | |
| 3 | DP-QPSK | 833 | 238 | 2088960 | | 522240 |
| | DP-16QAM | 1666 | 476 | 4177920 | 522240 | |
| 4 | DP-QPSK | 1190 | 84 | 2983936 | | 745984 |
| | DP-16QAM | 2380 | 168 | 5967872 | 745984 | |

In an example, in a scenario using DP-QPSK symbol mapping, a quantity of rows is r_{DP-QPSK} = 119, and a quantity of padding bits is d_{pad}=546. As shown in FIG. 8, the first bit set includes the r_{DP-QPSK} = 119 rows and q=2056 columns of bits, the convolutional interleaver includes the P=16 delay lines, the difference between the two adjacent delay lines is the Q=2 storage units, and each storage unit includes the d=K=112 bits. A quantity of fifth bit sets obtained through the first data processing is d₅ = 299008 , and a quantity of DP-QPSK symbols corresponding to the fifth bit set is ${s}_{DP - QPSK} = \frac{{d}_{5}}{4} = 74752$.

In another example, in a scenario using DP-16QAM symbol mapping, a quantity of rows is r_{DP-16QAM} = 238, and a quantity of padding bits is d_{pad}=1092. As shown in FIG. 8, the first bit set includes the f_{DP-QPSK} = 238 rows and q=2056 columns of bits, the convolutional interleaver includes the P=16 delay lines, the difference between the two adjacent delay lines is the Q=2 storage units, and each storage unit includes the d=K=112 bits. A quantity of fifth bit sets obtained through the first data processing is d₅ = 598016, and a quantity of DP-16QAM symbols corresponding to the fifth bit set is ${s}_{DP - 16 QAM} = \frac{{d}_{5}}{8} = 74752$.

Embodiment 4: Inner encoding uses (126, 110) encoding. To be specific, a length of an inner codeword is N=126 bits, and an inner code information length is K=110 bits.

For example, an inner code uses BCH (126, 110), is obtained by first shortening, by three bits, a BCH (127,113) code that is constructed over a finite field GF(2⁷) with 2-bit error correction to obtain BCH (124, 110), and performing double-bit extension to add odd parity and even parity, and therefore may also be denoted as double-bit extended DE-BCH (126, 110).

A received data sequence includes a plurality of rows of bits, and each row includes q=2056 bits. A first bit set of a total of 2056×r bits in r rows and q=2056 columns of bits is obtained from the received data sequence. r is an integer multiple of 119, that is, r=119×L, where L is a positive integer.

Outer encoding (First FEC encoding) is performed L times on the first bit set including 2056×r=2056×119×L=244664×L bits, where every 244664 bits in the first bit set are encoded to obtain a total of 261086 encoded bits, and a total of 261086×L encoded bits are obtained, and are referred to as the second bit set. Herein, L is also referred to as a quantity of SC code codeword groups.

d_{pad} padding bits are added to the second bit set including 261086×L bits, to obtain a third bit set of 261086×L+d_{pad} bits. Optionally, the 261086×L+d_{pad} bits are further scrambled, so that 0s and 1s in scrambled bit data tend to have more equal probabilities, thereby achieving direct current balance, which facilitates receiving at a receiver.

Next, convolutional interleaving is performed on the third bit set to obtain a fourth bit set whose length is 261086×L+d_{pad} bits. A convolutional interleaver includes P=16 delay lines, a difference between two adjacent delay lines is Q=2 storage units, and each storage unit includes d=K bits. In addition, 261086×L+d_{pad}=R×K.

Then, inner encoding is performed on every K=110 bits in the fourth bit set to obtain N=126 inner codeword bits, so as to a fifth bit set of a total of d₅ =R×N=(261086×L+ d_{pad} )/K×N=(261086×L+ d_{pad} )/110×126 bits. In addition, second data processing including symbol mapping and polarization distribution is performed.

When DP-16QAM is used for the symbol mapping, a quantity of DP-16QAM symbols corresponding to the fifth bit set of d₅ =(261086×L+ d_{pad} )/K×N bits is s_{DP-16QAM} = d₅/ 8=(261086×L+d_{pad})/K×N/8=(261086×L+d_{pad})/110×126/8, where L=r/119.

When DP-QPSK is used for the symbol mapping, a quantity of DP-QPSK symbols corresponding to the fifth bit set of d₅ =(261086×L+ d_{pad} )/K×N bits is s_{DP-QPSK} = d₅/ 4=(261086×L+d_{pad})/K×N/4=(261086×L+d_{pad})/110×126/4, where L=r/119.

The following table provides some parameter combinations, including the quantity r of rows, the quantity d_{pad} of padding bits, the quantity d₅ of bits in the fifth bit set, the quantity s_{DP-16QAM} of DP-16QAM symbols corresponding to the fifth bit set, and the quantity s_{DP-QPSK} of DP-QPSK symbols corresponding to the fifth bit set.

**Table 7**

| Sequence number | r | d_{pad} | d₅ | s_{DP-16QAM} | s_{DP-QPSK} |
|---|---|---|---|---|---|
| 1 | 119 | 1154 | 300384 | 37548 | 75096 |
| 2 | 238 | 548 | 598752 | 74844 | 149688 |
| 3 | 357 | 1702 | 899136 | 112392 | 224784 |
| 4 | 476 | 1096 | 1197504 | 149688 | 299376 |
| 5 | 595 | 490 | 1495872 | 186984 | 373968 |
| 6 | 714 | 1644 | 1796256 | 224532 | 449064 |
| 7 | 833 | 1038 | 2094624 | 261828 | 523656 |
| 8 | 952 | 432 | 2392992 | 299124 | 598248 |
| 9 | 1071 | 1586 | 2693376 | 336672 | 673344 |
| 10 | 1190 | 980 | 2991744 | 373968 | 747936 |
| 11 | 1309 | 374 | 3290112 | 411264 | 822528 |
| 12 | 1428 | 1528 | 3590496 | 448812 | 897624 |
| 13 | 1547 | 922 | 3888864 | 486108 | 972216 |
| 14 | 1666 | 316 | 4187232 | 523404 | 1046808 |
| 15 | 1785 | 1470 | 4487616 | 560952 | 1121904 |
| 16 | 1904 | 864 | 4785984 | 598248 | 1196496 |
| 17 | 2023 | 258 | 5084352 | 635544 | 1271088 |
| 18 | 2142 | 1412 | 5384736 | 673092 | 1346184 |
| 19 | 2261 | 806 | 5683104 | 710388 | 1420776 |
| 20 | 2380 | 200 | 5981472 | 747684 | 1495368 |

It should be noted that a larger value of the quantity r of rows indicates a larger quantity of dual-polarization symbols corresponding to the fifth bit set, resulting in higher complexity; but the larger quantity of dual-polarization symbols indicates lower framing redundancy introduced in DSP framing. The appropriate quantity r of rows may be selected based on different scenario requirements, to implement an effective compromise between complexity and framing redundancy.

A quantity of rows in a first bit set in a DP-16QAM modulation scenario is represented as r_{DP-16QAM}, and a quantity of rows in a first bit set in a DP-QPSK modulation scenario is represented as r_{DP-QPSK}. To make used data processing better compatible with the DP-16QAM and DP-QPSK modulation, f_{DP-16QAM} may be selected as twice r_{DP-QPSK} . In this case, s_{DP-16QAM} = s_{DP-QPSK}, so that structures of DSP frames obtained through the second data processing are the same. The following table lists corresponding parameter combinations.

**Table 8**

| Sequence number | Modulation format | r | d_{pad} | d₅ | s_{DP-16QAM} | s_{DP-QPSK} |
|---|---|---|---|---|---|---|
| 1 | DP-QPSK | 238 | 548 | 598752 | | 149688 |
| | DP-16QAM | 476 | 1096 | 1197504 | 149688 | |
| 2 | DP-QPSK | 595 | 490 | 1495872 | | 373968 |
| | DP-16QAM | 1190 | 980 | 2991744 | 373968 | |
| 3 | DP-QPSK | 952 | 432 | 2392992 | | 598248 |
| | DP-16QAM | 1904 | 864 | 4785984 | 598248 | |

In an example, in a scenario using DP-QPSK symbol mapping, a quantity of rows is r_{DP-QPSK} = 238, and a quantity of padding bits is d_{pad}=548. As shown in FIG. 8, the first bit set includes the r_{DP-QPSK} = 238 rows and q=2056 columns of bits, the convolutional interleaver includes the P=16 delay lines, the difference between the two adjacent delay lines is the Q=2 storage units, and each storage unit includes the d=K=110 bits. A quantity of fifth bit sets obtained through the first data processing is d₅ = 598752 , and a quantity of DP-QPSK symbols corresponding to the fifth bit set is ${s}_{DP - QPSK} = \frac{{d}_{5}}{4} = 149688$.

In another example, in a scenario using DP-16QAM symbol mapping, a quantity of rows is r_{DP-16QAM} = 238, and a quantity of padding bits is d_{pad}=1092. As shown in FIG. 8, the first bit set includes the r_{DP-QPSK} = 476 rows and q=2056 columns of bits, the convolutional interleaver includes the P=16 delay lines, the difference between the two adjacent delay lines is the Q=2 storage units, and each storage unit includes the d=K=110 bits. A quantity of fifth bit sets obtained through the first data processing is d₅ = 1197504, and a quantity of DP-16QAM symbols corresponding to the fifth bit set is ${s}_{DP - 16 QAM} = \frac{{d}_{5}}{8} = 149688$.

Embodiment 5: Inner encoding uses (136, 119) encoding. To be specific, a length of an inner codeword is N=136 bits, and an inner code information length is K=119 bits.

For example, an inner code uses BCH (136, 119), is obtained by first shortening, by 120 bits, a BCH (255, 239) code that is constructed over a finite field GF(2⁷) with 2-bit error correction to obtain BCH (135, 119), and performing single-bit extension, and therefore may also be denoted as single-bit extended E-BCH (136, 119). In some specific application embodiments, the inner code BCH (136, 119) may alternatively be obtained by first adding the BCH (255, 239) by one bit for extension to obtain E-BCH (256, 239), and then shortening 120 bits to obtain the single-bit extended E-BCH (136,119). This is not specifically limited herein.

A received data sequence includes a plurality of rows of bits, and each row includes q=2056 bits. A first bit set of a total of 2056×r bits in r rows and q=2056 columns of bits is obtained from the received data sequence. r is an integer multiple of 119, that is, r=119×L, where L is a positive integer.

Outer encoding (First FEC encoding) is performed L times on the first bit set including 2056×r=2056×119×L=244664×L bits, where every 244664 bits in the first bit set are encoded to obtain a total of 261086 encoded bits, and a total of 261086×L encoded bits are obtained, and are referred to as the second bit set. Herein, L is also referred to as a quantity of SC code codeword groups.

d_{pad} padding bits are added to the second bit set including 261086×L bits, to obtain a third bit set of 261086×L+d_{pad} bits. Optionally, the 261086×L+d_{pad} bits are further scrambled, so that 0s and 1s in scrambled bit data tend to have more equal probabilities, thereby achieving direct current balance, which facilitates receiving at a receiver.

Next, convolutional interleaving is performed on the third bit set to obtain a fourth bit set whose length is 261086×L+d_{pad} bits. A convolutional interleaver includes P=16 delay lines, a difference between two adjacent delay lines is Q=2 storage units, and each storage unit includes d=K bits. In addition, 261086×L+d_{pad}=R×K.

Then, inner encoding is performed on every K=119 bits in the fourth bit set to obtain N=136 inner codeword bits, so as to a fifth bit set of a total of d₅ =R×N=(261086×L+ d_{pad} )/K×N=(261086×L+ d_{pad} )/119×136 bits. In addition, second data processing including symbol mapping and polarization distribution is performed.

When DP-16QAM is used for the symbol mapping, a quantity of DP-16QAM symbols corresponding to the fifth bit set of d₅ =(261086×L+ d_{pad} )/K×N bits is s_{DP-16QAM} = d₅/ 8=(261086×L+d_{pad})/K×N/8=(261086×L+d_{pad})/119×136/8=(261086×L+d_{pad})/7, where L=r/119.

When DP-QPSK is used for symbol mapping, a quantity of DP-QPSK symbols corresponding to the fifth bit set of d₅ =(261086×L+ d_{pad} )/K×N bits is s_{DP-QPSK} = d₅/ 4 =(261086×L+ d_{pad} )/K×N/4=(261086×L+ d_{pad} )/119×136/4=(261086×L+ d_{pad} )/7×2, where L=r/119.

The following table provides some parameter combinations, including the quantity r of rows, the quantity d_{pad} of padding bits, the quantity d₅ of bits in the fifth bit set, the quantity s_{DP-16QAM} of DP-16QAM symbols corresponding to the fifth bit set, and the quantity s_{DP-QPSK} of DP-QPSK symbols corresponding to the fifth bit set.

**Table 9**

| Sequence number | r | d_{pad} | d₅ | s_{DP-16QAM} | s_{DP-QPSK} |
|---|---|---|---|---|---|
| 1 | 119 | 1666 | 300288 | 37536 | 75072 |
| 2 | 238 | 1428 | 598400 | 74800 | 149600 |
| 3 | 357 | 1190 | 896512 | 112064 | 224128 |
| 4 | 476 | 952 | 1194624 | 149328 | 298656 |
| 5 | 595 | 714 | 1492736 | 186592 | 373184 |
| 6 | 714 | 476 | 1790848 | 223856 | 447712 |
| 7 | 833 | 238 | 2088960 | 261120 | 522240 |
| 8 | 952 | 1904 | 2389248 | 298656 | 597312 |
| 9 | 1071 | 1666 | 2687360 | 335920 | 671840 |
| 10 | 1190 | 1428 | 2985472 | 373184 | 746368 |
| 11 | 1309 | 1190 | 3283584 | 410448 | 820896 |
| 12 | 1428 | 952 | 3581696 | 447712 | 895424 |
| 13 | 1547 | 714 | 3879808 | 484976 | 969952 |
| 14 | 1666 | 476 | 4177920 | 522240 | 1044480 |
| 15 | 1785 | 238 | 4476032 | 559504 | 1119008 |
| 16 | 1904 | 0 | 4774144 | 596768 | 1193536 |
| 17 | 2023 | 1666 | 5074432 | 634304 | 1268608 |
| 18 | 2142 | 1428 | 5372544 | 671568 | 1343136 |
| 19 | 2261 | 1190 | 5670656 | 708832 | 1417664 |
| 20 | 2380 | 952 | 5968768 | 746096 | 1492192 |

It should be noted that a larger value of the quantity r of rows indicates a larger quantity of dual-polarization symbols corresponding to the fifth bit set, resulting in higher complexity; but the larger quantity of dual-polarization symbols indicates lower framing redundancy introduced in DSP framing. The appropriate quantity r of rows may be selected based on different scenario requirements, to implement an effective compromise between complexity and framing redundancy.

A quantity of rows in a first bit set in a DP-16QAM modulation scenario is represented as r_{DP-16QAM}, and a quantity of rows in a first bit set in a DP-QPSK modulation scenario is represented as r_{DP-QPSK}. To make used data processing better compatible with the DP-16QAM and DP-QPSK modulation, f_{DP-16QAM} may be selected as twice r_{DP-QPSK} . In this case, s_{DP-16QAM} = s_{DP-QPSK}, so that structures of DSP frames obtained through the second data processing are the same. The following table lists corresponding parameter combinations.

**Table 10**

| Sequence number | Modulation format | r | d_{pad} | d₅ | s_{DP-16QAM} | s_{DP-QPSK} |
|---|---|---|---|---|---|---|
| 1 | DP-QPSK | 476 | 952 | 1194624 | | 298656 |
| | DP-16QAM | 952 | 1904 | 2389248 | 298656 | |
| 2 | DP-QPSK | 595 | 714 | 1492736 | | 373184 |
| | DP-16QAM | 1190 | 1428 | 2985472 | 373184 | |
| 3 | DP-QPSK | 833 | 238 | 2088960 | | 522240 |
| | DP-16QAM | 1666 | 476 | 4177920 | 522240 | |

In an example, in a scenario using DP-QPSK symbol mapping, a quantity of rows is r_{DP-QPSK} = 476, and a quantity of padding bits is d_{pad}=952. As shown in FIG. 8, the first bit set includes the r_{DP-QPSK} = 476 rows and q=2056 columns of bits, the convolutional interleaver includes the P=16 delay lines, the difference between the two adjacent delay lines is the Q=2 storage units, and each storage unit includes the d=K=119 bits. A quantity of fifth bit sets obtained through the first data processing is d₅ = 1194624 , and a quantity of DP-QPSK symbols corresponding to the fifth bit set is ${s}_{DP - QPSK} = \frac{{d}_{5}}{4} = 298656$.

In another example, in a scenario using DP-16QAM symbol mapping, a quantity of rows is r_{DP-16QAM} = 952, and a quantity of padding bits is d_{pad}=1904. As shown in FIG. 8, the first bit set includes the r_{DP-QPSK} = 476 rows and q=2056 columns of bits, the convolutional interleaver includes the P=16 delay lines, the difference between the two adjacent delay lines is the Q=2 storage units, and each storage unit includes the d=K=119 bits. A quantity of fifth bit sets obtained through the first data processing is d₅ = 2389248, and a quantity of DP-16QAM symbols corresponding to the fifth bit set is ${s}_{DP - 16 QAM} = \frac{{d}_{5}}{8} = 298656$.

Embodiment 6: Inner encoding uses (135, 119) encoding. To be specific, a length of an inner codeword is N=135 bits, and an inner code information length is K=119 bits.

For example, an inner code uses BCH (135, 119), and is obtained by first shortening, by 120 bits, a BCH (255, 239) code that is constructed over a finite field GF(2⁷) with 2-bit error correction.

A received data sequence includes a plurality of rows of bits, and each row includes q=2056 bits. A first bit set of a total of 2056×r bits in r rows and q=2056 columns of bits is obtained from the received data sequence. r is an integer multiple of 119, that is, r=119×L, where L is a positive integer.

Outer encoding (First FEC encoding) is performed L times on the first bit set including 2056×r=2056×119×L=244664×L bits, where every 244664 bits in the first bit set are encoded to obtain a total of 261086 encoded bits, and a total of 261086×L encoded bits are obtained, and are referred to as the second bit set. Herein, L is also referred to as a quantity of SC code codeword groups.

d_{pad} padding bits are added to the second bit set including 261086×L bits, to obtain a third bit set of 261086×L+d_{pad} bits. Optionally, the 261086×L+d_{pad} bits are further scrambled, so that 0s and 1s in scrambled bit data tend to have more equal probabilities, thereby achieving direct current balance, which facilitates receiving at a receiver.

Next, convolutional interleaving is performed on the third bit set to obtain a fourth bit set whose length is 261086×L+d_{pad} bits. A convolutional interleaver includes P=16 delay lines, a difference between two adjacent delay lines is Q=2 storage units, and each storage unit includes d=K bits. In addition, 261086×L+d_{pad}=R×K.

Then, inner encoding is performed on every K=119 bits in the fourth bit set to obtain N=135 inner codeword bits, so as to a fifth bit set of a total of d₅ =R×N=(261086×L+ d_{pad} )/K×N=(261086×L+ d_{pad} )/119×135 bits. In addition, second data processing including symbol mapping and polarization distribution is performed.

When DP-16QAM is used for the symbol mapping, a quantity of DP-16QAM symbols corresponding to the fifth bit set of d₅ =(261086×L+ d_{pad} )/K×N bits is s_{DP-16QAM} = d₅/ 8=(261086×L+d_{pad})/K×N/8=(261086×L+d_{pad})/119×135/8, where L=r/119.

When DP-QPSK is used for the symbol mapping, a quantity of DP-QPSK symbols corresponding to the fifth bit set of d₅ =(261086×L+ d_{pad} )/K×N bits is s_{DP-QPSK} = d₅/ 4=(261086×L+d_{pad})/K×N/4=(261086×L+d_{pad})/119×135/4, where L=r/119.

The following table provides some parameter combinations, including the quantity r of rows, the quantity d_{pad} of padding bits, the quantity d₅ of bits in the fifth bit set, the quantity s_{DP-16QAM} of DP-16QAM symbols corresponding to the fifth bit set, and the quantity s_{DP-QPSK} of DP-QPSK symbols corresponding to the fifth bit set.

**Table 11**

| Sequence number | r | d_{pad} | d₅ | s_{DP-16QAM} | s_{DP-QPSK} |
|---|---|---|---|---|---|
| 1 | 119 | 1666 | 298080 | 37260 | 74520 |
| 2 | 238 | 1428 | 594000 | 74250 | 148500 |
| 3 | 357 | 1190 | 889920 | 111240 | 222480 |
| 4 | 476 | 952 | 1185840 | 148230 | 296460 |
| 5 | 595 | 714 | 1481760 | 185220 | 370440 |
| 6 | 714 | 476 | 1777680 | 222210 | 444420 |
| 7 | 833 | 238 | 2073600 | 259200 | 518400 |
| 8 | 952 | 1904 | 2371680 | 296460 | 592920 |
| 9 | 1071 | 1666 | 2667600 | 333450 | 666900 |
| 10 | 1190 | 1428 | 2963520 | 370440 | 740880 |
| 11 | 1309 | 1190 | 3259440 | 407430 | 814860 |
| 12 | 1428 | 952 | 3555360 | 444420 | 888840 |
| 13 | 1547 | 714 | 3851280 | 481410 | 962820 |
| 14 | 1666 | 476 | 4147200 | 518400 | 1036800 |
| 15 | 1785 | 238 | 4443120 | 555390 | 1110780 |
| 16 | 1904 | 0 | 4739040 | 592380 | 1184760 |
| 17 | 2023 | 1666 | 5037120 | 629640 | 1259280 |
| 18 | 2142 | 1428 | 5333040 | 666630 | 1333260 |
| 19 | 2261 | 1190 | 5628960 | 703620 | 1407240 |
| 20 | 2380 | 952 | 5924880 | 740610 | 1481220 |

It should be noted that a larger value of the quantity r of rows indicates a larger quantity of dual-polarization symbols corresponding to the fifth bit set, resulting in higher complexity; but the larger quantity of dual-polarization symbols indicates lower framing redundancy introduced in DSP framing. The appropriate quantity r of rows may be selected based on different scenario requirements, to implement an effective compromise between complexity and framing redundancy.

A quantity of rows in a first bit set in a DP-16QAM modulation scenario is represented as r_{DP-16QAM}, and a quantity of rows in a first bit set in a DP-QPSK modulation scenario is represented as r_{DP-QPSK}. To make used data processing better compatible with the DP-16QAM and DP-QPSK modulation, r_{DP-16QAM} may be selected as twice r_{DP-QPSK} . In this case, s_{DP-16QAM} = s_{DP-QPSK}, so that structures of DSP frames obtained through the second data processing are the same. The following table lists corresponding parameter combinations.

**Table 12**

| Sequence number | Modulation format | r | d_{pad} | d₅ | s_{DP-16QAM} | s_{DP-QPSK} |
|---|---|---|---|---|---|---|
| 1 | DP-QPSK | 476 | 952 | 1185840 | | 296460 |
| | DP-16QAM | 952 | 1904 | 2371680 | 296460 | |
| 2 | DP-QPSK | 595 | 714 | 1481760 | | 370440 |
| | DP-16QAM | 1190 | 1428 | 2963520 | 370440 | |
| 3 | DP-QPSK | 833 | 238 | 2073600 | | 518400 |
| | DP-16QAM | 1666 | 476 | 4147200 | 518400 | |

In an example, in a scenario using DP-QPSK symbol mapping, a quantity of rows is r_{DP-QPSK} = 476, and a quantity of padding bits is d_{pad}=952. As shown in FIG. 8, the first bit set includes the r_{DP-QPSK} = 476 rows and q=2056 columns of bits, the convolutional interleaver includes the P=16 delay lines, the difference between the two adjacent delay lines is the Q=2 storage units, and each storage unit includes the d=K=119 bits. A quantity of fifth bit sets obtained through the first data processing is d₅ = 1185840, and a quantity of DP-QPSK symbols corresponding to the fifth bit set is ${s}_{DP - QPSK} = \frac{{d}_{5}}{4} = 296460$.

In another example, in a scenario using DP-16QAM symbol mapping, a quantity of rows is r_{DP-16QAM} = 952, and a quantity of padding bits is d_{pad}=1904. As shown in FIG. 8, the first bit set includes the r_{DP-QPSK} = 952 rows and q=2056 columns of bits, the convolutional interleaver includes the P=16 delay lines, the difference between the two adjacent delay lines is the Q=2 storage units, and each storage unit includes the d=K=119 bits. A quantity of fifth bit sets obtained through the first data processing is d₅ = 2371680, and a quantity of DP-16QAM symbols corresponding to the fifth bit set is ${s}_{DP - 16 QAM} = \frac{{d}_{5}}{8} = 296460$.

It should be noted that, in the data processing shown in FIG. 3, FIG. 4, FIG. 5, and FIG. 6, the first data processing may alternatively be processing by using a plurality of lanes of data streams. The following describes several possible implementations.

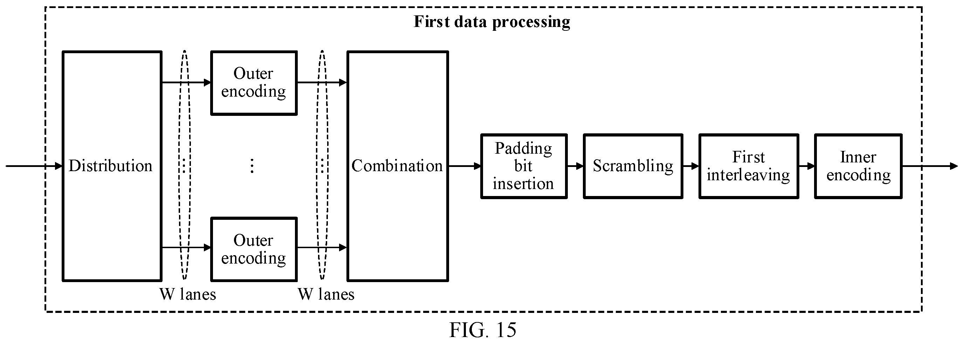

FIG. 15 is a diagram of another implementation of first data processing according to an embodiment of this application. As shown in FIG. 15, a received data sequence includes a plurality of rows of bits, and each row includes q=2056 bits. A first bit set of a total of 2056×r bits in r rows and q=2056 columns of bits is obtained from the received data sequence. r is an integer multiple of 119, that is, r=119×L, where L is a positive integer.

The first bit set including 2056×r=2056×119×L=244664×L bits is distributed to W lanes, and each lane includes 244664×L/W bits, which are denoted as a first bit subset. Herein, W is a positive integer greater than 1, and L is an integer multiple of W. In other words, a quantity r of rows is an integer multiple of W. Typically, a value of W is 2, 4, 8, 16, or the like.

Outer encoding (First FEC encoding) is performed L/W times on the first bit subset including 244664×L/W bits, where every 244664 bits in the first bit subset are encoded to obtain a total of 261086 encoded bits, and a total of 261086×L/W encoded bits are obtained, and are referred to as a second bit subset. The W second bit subsets are combined to obtain a second bit set including 261086×L bits.

d_{pad} padding bits are added to the second bit set including 261086×L bits, to obtain a third bit set of 261086×L+d_{pad} bits. Optionally, the 261086×L+d_{pad} bits are further scrambled, so that 0s and 1s in scrambled bit data tend to have more equal probabilities, thereby achieving direct current balance, which facilitates receiving at a receiver.

Next, convolutional interleaving is performed on the third bit set to obtain a fourth bit set whose length is 261086×L+d_{pad} bits. A convolutional interleaver includes P delay lines, a difference between two adjacent delay lines is Q storage units, and each storage unit includes d=K bits. In addition, 261086×L+d_{pad}=R×K.

Then, inner encoding is performed on every K bits in the fourth bit set to obtain N inner codeword bits, so as to a fifth bit set of a total of d₅=R×N=(261086×L+d_{pad})/K×N bits. In addition, second data processing including symbol mapping and polarization distribution is performed.

When DP-16QAM is used for the symbol mapping, a quantity of DP-16QAM symbols corresponding to the fifth bit set of the d₅ bits is s_{DP-16QAM} = d₅/8, where L=r/119.

When DP-QPSK is used for the symbol mapping, a quantity of DP-QPSK symbols corresponding to the fifth bit set of the d₅ bits is s_{DP-QPSK} = d₅/4, where L=r/119^{.}

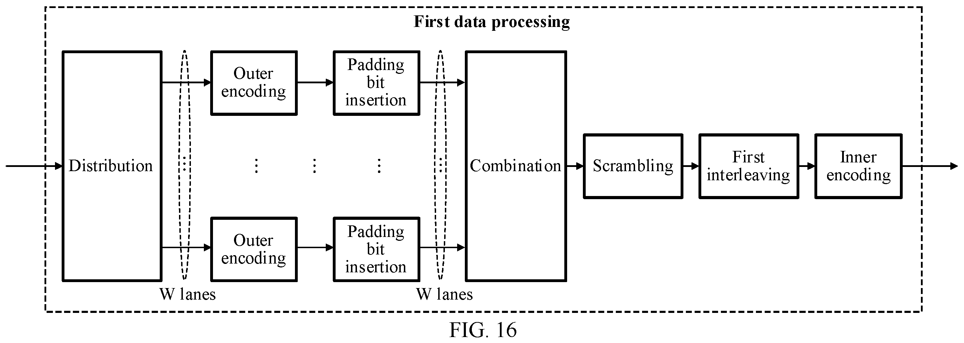

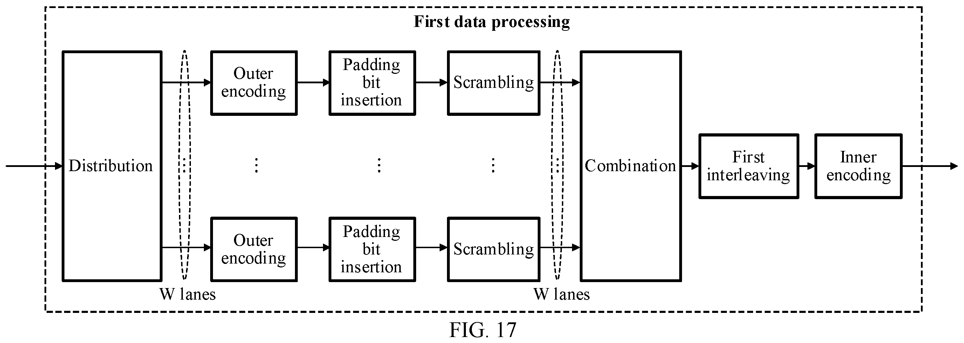

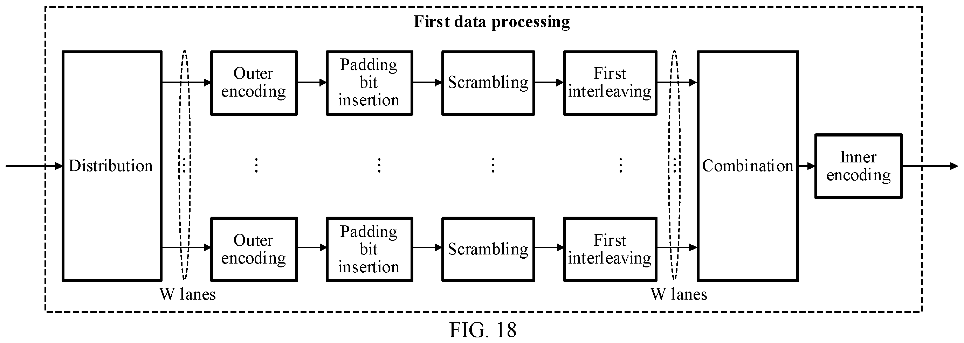

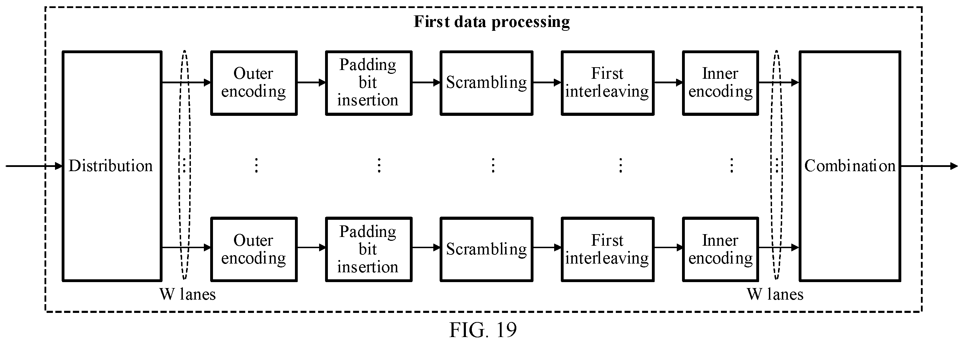

First data processing procedures shown in FIG. 16, FIG. 17, FIG. 18, and FIG. 19 may be obtained by appropriately transforming the first data processing procedure shown in FIG. 15. The following uses the first data processing shown in FIG. 16 as an example for description. For the first data processing procedures shown in FIG. 17, FIG. 18, and FIG. 19, refer to the foregoing descriptions and FIG. 16 for understanding. Details are not described herein again.

A received data sequence includes a plurality of rows of bits, and each row includes q=2056 bits. A first bit set of a total of 2056×r bits in r rows and q=2056 columns of bits is obtained from the received data sequence. r is an integer multiple of 119, that is, r=119×L, where L is a positive integer.

The first bit set including 2056×r=2056×119×L=244664×L bits is distributed to W lanes, and each lane includes 244664×L/W bits, which are denoted as a first bit subset. Herein, W is a positive integer greater than 1, and L is an integer multiple of W. In other words, a quantity r of rows is an integer multiple of W. Typically, a value of W is 2, 4, 8, 16, or the like.

Outer encoding (First FEC encoding) is performed L/W times on the first bit subset including 244664×L/W bits, where every 244664 bits in the first bit subset are encoded to obtain a total of 261086 encoded bits, and a total of 261086×L/W encoded bits are obtained, and are referred to as a second bit subset.

d_{pad} padding bits are added to the second bit subset including 261086×L/W bits, to obtain a third bit subset of 261086×L/W+d̃_{pad} bits. The W third bit subsets are combined to obtain a third bit set including 261086×L+d_{pad} × W bits. Herein, d_{pad} × W = d_{pad}, in other words, the third bit set includes the d_{pad} padding bits, where d_{pad} is an integer multiple of W. Optionally, the 261086×L+d_{pad} bits are further scrambled, so that 0s and 1s in scrambled bit data tend to have more equal probabilities, thereby achieving direct current balance, which facilitates receiving at a receiver.

Next, convolutional interleaving is performed on the third bit set to obtain a fourth bit set whose length is 261086×L+d_{pad} bits. A convolutional interleaver includes P delay lines, a difference between two adjacent delay lines is Q storage units, and each storage unit includes d=K bits. In addition, 261086×L+d_{pad}=R×K.

Then, inner encoding is performed on every K bits in the fourth bit set to obtain N inner codeword bits, so as to a fifth bit set of a total of d₅=R×N=(261086×L+d_{pad})/K×N bits. In addition, second data processing including symbol mapping and polarization distribution is performed.

When DP-16QAM is used for the symbol mapping, a quantity of DP-16QAM symbols corresponding to the fifth bit set of the d₅ bits is s_{DP-16QAM} = d₅/8, where L=r/119.

When DP-QPSK is used for the symbol mapping, a quantity of DP-QPSK symbols corresponding to the fifth bit set of the d₅ bits is s_{DP-QPSK} = d₅/4, where L=r/119.

It should be understood that the first data processing procedures shown in FIG. 15, FIG. 16, FIG. 17, FIG. 18, and FIG. 19 are used, to be compatible with application scenarios with lower rates. For example, at a rate of 1.6T, the first data processing procedure in FIG. 15 is used, where W=4. In this case, the data processing procedure includes four outer encoding modules, and a rate of each outer encoding module is 400G. When two of the four outer encoding modules are not performed, the outer encoding modules may be used in a scenario of a rate of 800G, and the outer encoding modules do not need to be redesigned, to facilitate hardware development and implementation; or when three of the four outer encoding modules are not performed, the outer encoding modules may be used in a scenario of a rate of 400G, and the outer encoding module does not need to be redesigned, to facilitate hardware development and implementation.

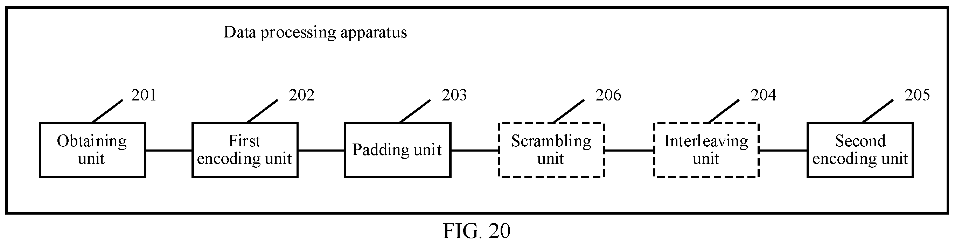

FIG. 20 is a diagram of a structure of a data processing apparatus according to an embodiment of this application. As shown in FIG. 20, the data processing apparatus includes an obtaining unit 201, a first encoding unit 202, a padding unit 203, an interleaving unit 204, and a second encoding unit 205. Optionally, the data processing apparatus further includes a scrambling unit 206. It should be understood that, in some possible scenarios, the interleaving unit 204 is optional, so that the data processing apparatus has a low latency. The obtaining unit 201 is configured to perform the operation in step 101, the first encoding unit 202 is configured to perform the operation in step 102, the padding unit 203 is configured to perform the operation in step 103, the interleaving unit 204 is configured to perform the operation in step 104, and the second encoding unit 205 is configured to perform the operation in step 105. It should be understood that the data processing apparatus provided in this application may alternatively be implemented in another manner. For example, division into the units in the foregoing apparatus is merely logical function division and may be other division in actual implementation. For example, a plurality of units or components may be combined or integrated into another system. In addition, functional units in embodiments of this application may be integrated into one processing unit, may be independent physical units, or two or more functional units may be integrated into one processing unit. The integrated unit may be implemented in a form of hardware, or may be implemented in a form of a software functional unit.

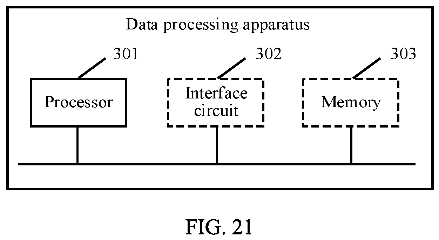

FIG. 21 is a diagram of another structure of a data processing apparatus according to an embodiment of this application. As shown in FIG. 21, the data processing apparatus includes a processor 301, and the processor is configured to perform the operations in step 101 to step 105. In a possible implementation, the processor 301 may include the obtaining unit 201, the first encoding unit 202, the padding unit 203, the interleaving unit 204, and the second encoding unit 205 that are shown in FIG. 20. Optionally, the data processing apparatus further includes an interface circuit 302. The interface circuit 302 may be a transceiver or an input/output interface. The interface circuit 302 is configured to: receive a signal from an apparatus other than the data processing apparatus and transmit the signal to the processor 301, or send a signal from the processor 301 to an apparatus other than the data processing apparatus. In a possible scenario, the interface circuit 302 is configured to: receive a data sequence, and transmit the data sequence to the processor 301. The processor obtains, from the data sequence, a first bit set on which outer encoding is to be performed. In another possible scenario, the processor 301 is further configured to perform the second data processing described in any one of the implementations in FIG. 3 to FIG. 6 to obtain a to-be-sent data frame, and the interface circuit 302 is configured to send the data frame. Optionally, the data processing apparatus may further include a memory 303. The memory 303 is configured to store program instructions and data.

An embodiment of this application further provides a chip. A circuit and one or more interfaces that are configured to implement a function of the processor 301 are integrated into the chip. In an example, a memory is integrated into the chip. In another example, when no memory is integrated into the chip, the chip may be connected to an external memory through an interface. The chip may complete the method steps in any one or more of the foregoing embodiments. Alternatively, the chip implements, based on program code stored in the memory, the actions performed by the data processing apparatus in the foregoing embodiments.

An embodiment of this application further provides a computer-readable storage medium, including a program or instructions. When the program or the instructions are run on a computer, the method performed by the processor 301 in the foregoing method embodiments is performed.

It should be understood that, the processor mentioned in embodiments of this application may be implemented by using hardware or by software. When the processor is implemented by using the hardware, the processor may be a logic circuit, an integrated circuit, or the like. When the processor is implemented by using software, the processor may be a general-purpose processor, and is implemented by reading software code stored in the memory.

In an example, the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor, or may be any conventional processor.

The memory in embodiments of this application may be a random access memory (random access memory, RAM), a flash memory, a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), a register, a hard disk drive, a removable hard disk, a CD-ROM, or any other form of storage medium well known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located in a network device or a terminal device. Certainly, the processor and the storage medium may alternatively exist as discrete components in a network device or a terminal device.

All or some of the foregoing embodiments may be implemented by using software, hardware, firmware, or any combination thereof.

When hardware is used for implementation, the data processing method provided in embodiments of this application may not be implemented by reading software code or instructions, for example, may be implemented by using a CPU, a DSP, an ASIC, an FPGA, another programmable logic device, a transistor logic device, a hardware component, or any combination thereof.

When software is used to implement embodiments, all or a part of embodiments may be implemented in a form of a computer program product. The computer program product includes one or more computer programs or instructions. When the computer programs or instructions are loaded and executed on a computer, procedures or functions in embodiments of this application are all or partially executed. The computer may be a general-purpose computer, a dedicated computer, a computer network, a network device, a terminal device, or another programmable apparatus. The computer program or the instructions may be stored in a computer-readable storage medium, or may be transmitted through the computer-readable storage medium. The computer-readable storage medium may be any usable medium that can be accessed by a computer, or a data storage device, such as a server, integrating one or more usable media. The usable medium may be a magnetic medium, for example, a floppy disk, a hard disk, or a magnetic tape; may be an optical medium, for example, a DVD; or may be a semiconductor medium, for example, a solid-state drive (solid-state drive, SSD).

Finally, it should be noted that the foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A data processing method for optical communication, comprising:
obtaining a first bit set, wherein the first bit set comprises d₁ bits, d₁=244664×L, and L is a positive integer;
performing first forward error correction FEC encoding on the first bit set to obtain a second bit set, wherein the second bit set comprises d₂ bits, every 261086 bits in the second bit set are obtained by performing the first FEC encoding on every 244664 bits in the first bit set, and d₂=261086×L;
adding d_{pad} padding bits to the second bit set to obtain a third bit set, wherein d_{pad} is an integer greater than or equal to 0; and
performing second FEC encoding on the third bit set to obtain a fourth bit set.

2. The method according to claim 1, wherein the d₁ bits in the first bit set are distributed in r rows and 2056 columns, and r=119×L.

3. The method according to claim 1 or 2, wherein every 261086 bits in the second bit set are distributed in 119 rows and 2194 columns, and first 2056 columns of the 2194 columns are used to carry 244664 bits in the first bit set.

4. The method according to any one of claims 1 to 3, wherein every 261086 bits in the second bit set comprise 244664 bits in the first bit set, 32 first-type bits, six second-type bits, and 16384 check bits obtained through the first FEC encoding.

5. The method according to any one of claims 1 to 4, wherein after adding the d_{pad} padding bits to the second bit set to obtain the third bit set, and before performing the second FEC encoding on the third bit set to obtain the fourth bit set, the method further comprises:
performing first interleaving on the third bit set.

6. The method according to claim 5, wherein performing the first interleaving on the third bit set comprises:
delaying bits in the third bit set based on P delay lines, wherein P is an integer greater than 1, a quantity of storage units comprised in each delay line is different, a delay line having a smallest quantity of storage units comprises zero storage units, a difference between quantities of storage units of every two adjacent delay lines is Q, each storage unit is configured to store d bits, input bits are sequentially input into the P delay lines based on sequence numbers of the P delay lines, each delay line receives d bits per input and outputs d bits per output, P×d consecutive bits output through convolutional interleaving comprise d bits output from each delay line, and both Q and d are integers greater than or equal to 1.

7. The method according to claim 6, wherein the fourth bit set comprises R codewords, a length of each codeword is N bits, each codeword comprises K information bits, R, N, K are all integers greater than 1, N is greater than K, the third bit set comprises R×K bits, R×K=261086×L+d_{pad}, K is an integer multiple of d, P×d is an integer multiple of K, and $R \times \frac{K}{d}$ is an integer multiple of P.

8. The method according to claim 7, wherein a third bit set obtained through the first interleaving comprises R rows and K columns of bits, K bits in each row in the third bit set obtained through the first interleaving are K bits output from $\frac{K}{d}$ delay lines, and performing the second FEC encoding on the third bit set to obtain the fourth bit set comprises:
performing the second FEC encoding on the K bits in each row in the third bit set obtained through the first interleaving, to obtain N bits of each codeword in the fourth bit set.

9. The method according to any one of claims 1 to 8, wherein the second FEC encoding uses BCH encoding or extended BCH encoding.

10. The method according to any one of claims 1 to 9, wherein after adding the d_{pad} padding bits to the second bit set to obtain the third bit set, and before performing the second FEC encoding on the third bit set to obtain the fourth bit set, the method further comprises:
scrambling the third bit set.

11. The method according to any one of claims 1 to 10, wherein after performing the second FEC encoding on the third bit set to obtain the fourth bit set, the method further comprises:
performing data processing on the fourth bit set, wherein the data processing comprises symbol mapping, second interleaving, polarization distribution, and framing.

12. The method according to any one of claims 2 to 11, wherein the fourth bit set comprises the R codewords, the length of each codeword is N bits, each codeword comprises the K information bits, R, N, and K are all integers greater than 1, and N is greater than K; and
K=113, and N=127; or
K=113, and N=128; or
K=112, and N=128; or
K=110, and N=126; or
K=119, and N=136; or
K=119, and N=135.

13. The method according to claim 12, wherein K=113, N=127, and r and d_{pad} satisfy one of the following conditions:
r=119, and d_{pad}=1074;
r=238, and d_{pad}=340;
r=357, and d_{pad}=1414;
r=476, and d_{pad}=680;
r=595, and d_{pad}=1754;
r=714, and d_{pad}=1020;
r=833, and d_{pad}=286;
r=952, and d_{pad}=1360;
r=1071, and d_{pad}=626;
r=1190, and d_{pad}=1700;
r=1309, and d_{pad}=966;
r=1428, and d_{pad}=232;
r=1547, and d_{pad}=1306;
r=1666, and d_{pad}=572;
r=1785, and d_{pad}=1646;
r=1904, and d_{pad}=912;
r=2023, and d_{pad}=178;
r=2142, and d_{pad}=1252;
r=2261, and d_{pad}=518; or
r=2380, and d_{pad}=1592.

14. The method according to claim 12, wherein K=113, N=128, and r and d_{pad} satisfy one of the following conditions:
r=119, and d_{pad}=1074;
r=238, and d_{pad}=340;
r=357, and d_{pad}=1414;
r=476, and d_{pad}=680;
r=595, and d_{pad}=1754;
r=714, and d_{pad}=1020;
r=833, and d_{pad}=286;
r=952, and d_{pad}=1360;
r=1071, and d_{pad}=626;
r=1190, and d_{pad}=1700;
r=1309, and d_{pad}=966;
r=1428, and d_{pad}=232;
r=1547, and d_{pad}=1306;
r=1666, and d_{pad}=572;
r=1785, and d_{pad}=1646;
r=1904, and d_{pad}=912;
r=2023, and d_{pad}=178;
r=2142, and d_{pad}=1252;
r=2261, and d_{pad}=518; or
r=2380, and d_{pad}=1592.

15. The method according to claim 12, wherein K=112, N=128, and r and d_{pad} satisfy one of the following conditions:
r=119, and d_{pad}=546;
r=238, and d_{pad}=1092;
r=357, and d_{pad}=1638;
r=476, and d_{pad}=392;
r=595, and d_{pad}=938;
r=714, and d_{pad}=1484;
r=833, and d_{pad}=238;
r=952, and d_{pad}=784;
r=1071, and d_{pad}=1330;
r=1190, and d_{pad}=84;
r=1309, and d_{pad}=630;
r=1428, and d_{pad}=1176;
r=1547, and d_{pad}=1722;
r=1666, and d_{pad}=476;
r=1785, and d_{pad}=1022;
r=1904, and d_{pad}=1568;
r=2023, and d_{pad}=322;
r=2142, and d_{pad}=868;
r=2261, and d_{pad}=1414; or
r=2380, and d_{pad}=168.

16. The method according to claim 12, wherein K=110, N=126, and r and d_{pad} satisfy one of the following conditions:
r=119, and d_{pad}=1154;
r=238, and d_{pad}=548;
r=357, and d_{pad}=1702;
r=476, and d_{pad}=1096;
r=595, and d_{pad}=490;
r=714, and d_{pad}=1644;
r=833, and d_{pad}=1038;
r=952, and d_{pad}=432;
r=1071, and d_{pad}=1586;
r=1190, and d_{pad}=980;
r=1309, and d_{pad}=374;
r=1428, and d_{pad}=1528;
r=1547, and d_{pad}=922;
r=1666, and d_{pad}=316;
r=1785, and d_{pad}=1470;
r=1904, and d_{pad}=864;
r=2023, and d_{pad}=258;
r=2142, and d_{pad}=1412;
r=2261, and d_{pad}=806; or
r=2380, and d_{pad}=200.

17. The method according to claim 12, wherein K=119, N=136, and r and d_{pad} satisfy one of the following conditions:
r=119, and d_{pad}=1666;
r=238, and d_{pad}=1428;
r=357, and d_{pad}=1190;
r=476, and d_{pad}=952;
r=595, and d_{pad}=714;
r=714, and d_{pad}=476;
r=833, and d_{pad}=238;
r=952, and d_{pad}=1904;
r=1071, and d_{pad}=1666;
r=1190, and d_{pad}=1428;
r=1309, and d_{pad}=1190;
r=1428, and d_{pad}=952;
r=1547, and d_{pad}=714;
r=1666, and d_{pad}=476;
r=1785, and d_{pad}=238;
r=1904, and d_{pad}=0;
r=2023, and d_{pad}=1666;
r=2142, and d_{pad}=1428;
r=2261, and d_{pad}=1190; or
r=2380, and d_{pad}=952.

18. The method according to claim 12, wherein K=119, N=135, and r and d_{pad} satisfy one of the following conditions:
r=119, and d_{pad}=1666;
r=238, and d_{pad}=1428;
r=357, and d_{pad}=1190;
r=476, and d_{pad}=952;
r=595, and d_{pad}=714;
r=714, and d_{pad}=476;
r=833, and d_{pad}=238;
r=952, and d_{pad}=1904;
r=1071, and d_{pad}=1666;
r=1190, and d_{pad}=1428;
r=1309, and d_{pad}=1190;
r=1428, and d_{pad}=952;
r=1547, and d_{pad}=714;
r=1666, and d_{pad}=476;
r=1785, and d_{pad}=238;
r=1904, and d_{pad}=0;
r=2023, and d_{pad}=1666;
r=2142, and d_{pad}=1428;
r=2261, and d_{pad}=1190; or
r=2380, and d_{pad}=952.

19. A data processing apparatus, wherein the data processing apparatus comprises: an obtaining unit, a first encoding unit, a padding unit, and a second encoding unit, wherein
the obtaining unit is configured to obtain a first bit set, wherein the first bit set comprises d₁ bits, d₁=244664×L, and L is a positive integer;
the first encoding unit is configured to perform first forward error correction FEC encoding on the first bit set to obtain a second bit set, wherein the second bit set comprises d₂ bits, every 261086 bits in the second bit set are obtained by performing the first FEC encoding on every 244664 bits in the first bit set, and d₂=261086×L;
the padding unit is configured to add d_{pad} padding bits to the second bit set to obtain a third bit set, wherein d_{pad} is an integer greater than or equal to 0; and
the second encoding unit is configured to perform second FEC encoding on the third bit set to obtain a fourth bit set.

20. The data processing apparatus according to claim 19, wherein the d₁ bits in the first bit set are distributed in r rows and 2056 columns, and r=119×L.

21. The data processing apparatus according to claim 19 or 20, wherein every 261086 bits in the second bit set are distributed in 119 rows and 2194 columns, and first 2056 columns of the 2194 columns are used to carry 244664 bits in the first bit set.

22. The data processing apparatus according to any one of claims 19 to 21, wherein the fourth bit set comprises R codewords, a length of each codeword is N bits, each codeword comprises K information bits, R, N, and K are all integers greater than 1, and N is greater than K; and
K=113, and N=127; or
K=113, and N=128; or
K=112, and N=128; or
K=110, and N=126; or
K=119, and N=136; or
K=119, and N=135.

23. A data processing apparatus, wherein the data processing apparatus comprises a processor, and the processor is configured to perform the method according to any one of claims 1 to 18.

24. The data processing apparatus according to claim 23, wherein the data processing apparatus further comprises an interface circuit, the processor is further configured to perform data processing on a fourth bit set to obtain a data frame, and the interface circuit is configured to send the data frame.

25. A chip, wherein the chip comprises a processor, and the processor is configured to perform the method according to any one of claims 1 to 18.
